# EUROPÄISCHE PATENTSCHRIFT

(11) **EP 3 108 285 B1**
(45) Veröffentlichungstag und Bekanntmachung des Hinweises auf die Patenterteilung: **10.01.2024**
(21) Anmeldenummer: 15705501.3
(22) Anmeldetag: 18.02.2015
(51) Int. Cl.: G02B 26/02, H10K 50/00, H01J 31/12, H10K 50/86, H10K 59/10, H10K 50/858

(54) **ANZEIGEVORRICHTUNG MIT VERBESSERTEM KONTRAST**
DISPLAY DEVICE WITH BETTER CONTRAST
DISPOSITIF D'AFFICHAGE À CONTRASTE AMÉLIORÉ

(30) Priorität: 19.02.2014 DE 102014002272; 30.06.2014 DE 102014009677
(43) Veröffentlichungstag der Anmeldung: 28.12.2016
(73) Patentinhaber: PA.Cotte Family Holding GmbH, 92224 Amberg (DE)
(72) Erfinder: COTTE, Pierre-Alain, 92224 Amberg (DE)
(74) Vertreter: reuteler & cie SA
(86) Internationale Anmeldenummer: PCT/EP2015/000354
(87) Internationale Veröffentlichungsnummer: WO 2015/124291

(56) Entgegenhaltungen:
- WO-A1-2005/059636
- WO-A1-2013/099839
- US-A1- 2003 025 849
- US-A1- 2004 051 447
- US-A1- 2007 085 471
- US-A1- 2007 222 922

## Beschreibung

Die Erfindung betrifft eine Farbanzeigevorrichtung mit einer Anzeigefläche mit mehreren Pixeln. Solche Anzeigevorrichtungen sind im Stand der Technik z.B. als LCD-Anzeigevorrichtungen oder OLED-Anzeigevorrichtungen bekannt. Nachteilig an solchen Anzeigevorrichtungen ist der begrenzte Kontrastumfang, den diese Anzeigevorrichtungen aufweisen. Die US 2008/0024470 zeigt ein unsichtbares, lichtdurchlässiges Anzeigesystem, in einem lichtundurchlässigen Material. Im Wesentlichen unsichtbare, verjüngte, lichtdurchlässige Löcher sind in einem lichtdurchlässigen Muster durch zumindest einen Teil des lichtbeständigen Materials unter Verwendung eines Laserstrahls mit einer Brennweite kleiner als der kleinste Durchmesser der kegelförmigen Löcher durchsetzt. Die Hauptzielrichtung besteht in einer Anwendung als LED-Indikatoren, z.B. für Batterie oder Stand-By-Lichtsignale, die unsichtbar in ein Material integriert werden sollen, wobei die Löcher an sich sehr klein sein sollen, der Abstand zwischen den Löchern an das Auflösungsvermögen des Betrachters angepasst ist.

Die US 2007/085471 betrifft eine Vorrichtung mit organischer Leuchtdiode (OLED), umfassend eine erste Elektrode und eine zweite Elektrode mit einer oder mehreren dazwischen gebildeten organischen Schichten, wobei mindestens eine organische Schicht lichtemittierend ist, wobei die erste und die zweite Elektrode einen oder mehrere lichtemittierende Bereiche definieren, und wobei mindestens eine der ersten und zweiten Elektroden reflektierende und transparente Abschnitte in dem lichtemittierenden Bereich umfasst.

Eine weitere Farbanzeigevorrichtung ist aus der US 2004/051447 A1 bekannt.

Aufgabe der vorliegenden Erfindung ist es, Farbanzeigevorrichtungen der erst genannten Art, d.h. Farbanzeigevorrichtungen mit einer Anzeigefläche mit mehreren Pixeln, z.B. LCD- oder OLED-Anzeigevorrichtungen, zu verbessern, insbesondere die Anzeigequalität und/oder den visuellen Eindruck einer solchen Anzeige zu verbessern und/oder die Anzeigevorrichtung energieeffizienter zu gestalten.

Die Aufgabe wird durch die unabhängigen Ansprüche gelöst. Vorteilhafte Weiterbildungen sind in den Unteransprüchen definiert.

Insbesondere wird die Aufgabe gelöst durch eine Farbanzeigevorrichtung mit einer Anzeigefläche bestehend aus nicht leuchtenden Flächen und Leuchtflächen, wobei die Flächenschwerpunkte benachbarter Leuchtflächen gegenseitige Abstände aufweisen, die kleiner sind, als das Auflösungsvermögen eines Betrachters und wobei der Anteil der nicht leuchtenden Flächen an der gesamten Anzeigefläche mehr als 70% beträgt.

Hierdurch wird zunächst eine Anzeigevorrichtung bereitgestellt, welche auf bekannte Weise so hochauflösend ist, dass der menschliche Betrachter die einzelnen Leuchtflächen nicht voneinander unterscheiden kann. Darüberhinaus wird jedoch ein besonderer Vorteil durch eine bewusste und dem allgemeinen Bestreben einer Leuchtflächen an der Anzeigefläche und eine Vergrößerung der nicht leuchtenden Flächen zwischen den Leuchtflächen erhalten. Hierdurch werden dunkle Bereiche dann auch in der Tat dunkel bleiben können da sie im Verhältnis viel größer als die leuchtenden Flächen sind, noch verstärkt z.B. bei einem Anteil der nicht leuchtenden Flächen von z.B. mehr als 95% (ein bevorzugtes Merkmal dieser Erfindung, siehe unten), und weniger lichtreflektierend sind, was insbesondere vorteilhaft ist in dunkleren Teilen des Bildes und/oder bei starkem Umgebungslicht. Das wiederum bringt ein großes Stromersparnis-Potential mit sich, da weniger Licht notwendig ist, um einen guten Kontrastwert zu erreichen (bei vorhandenem Umgebungslicht). Weiterhin wird eine zusätzliche Kontrasterhöhung erzielt, da zwischen den einzelnen Leuchtflächen ein größere Trennung durch nicht leuchtende Flächen vorhanden ist und somit einerseits kein oder nur ein wesentlich reduzierter Leucht-"Crosstalk" zwischen benachbarten Leuchtflächen erfolgt.

Unter einer Farbanzeigevorrichtung bzw. einem Display wird eine Einrichtung verstanden, welche eingerichtet ist, bevorzugt digitale oder digitalisierte Bilder, Text, Graphik oder Video, welche jeweils aus einzelnen Pixeln zusammengesetzt ist, anzuzeigen. Z.B. ist sie ein Display eines Handheld-Devices (z.B. Mobilfunkgerät/Smartphone, Armband-/Taschenuhr, Pocket-Mediaplayer, Tablet etc.), eines konventionellen Computers (Laptop, Desktop etc.), eines Fernsehers oder einer Werbe-/Informationsanzeigetafel (z.B. in U-Bahnen, Sportstadien oder Kaufhäuser, an Hauswänden etc.).

Die Anzeigefläche ist eine dem Betrachter zugewandte Fläche der Anzeigevorrichtung, innerhalb welcher die einzelnen Pixel angeordnet sind. Die Anzeigefläche ist bevorzugt begrenzt durch eine (imaginäre) Linie, welche entlang der äußersten Pixel, bevorzugt entlang der äußersten Leuchtflächen der Anzeigevorrichtung verläuft. Bevorzugt verläuft um die Anzeigefläche herum in der Regel ein Rahmen, welcher z.B. für mechanische Stabilität sorgt, der jedoch umso vorteilhafter für z.B. das Design ist, je dünner er ist. Unter Leuchtfläche wird eine Fläche verstanden, von welcher aus in einem eingeschaltetem Modus Lichtstrahlen zu dem Betrachter ausgehen. Die Lichtstrahlen können entweder direkt in der Fläche generiert bzw. ausgesendet werden (z.B. durch eine in der Leuchtfläche angeordnete aktive Lichtquelle wie einer LED) oder sie können durch die Leuchtfläche zu dem Betrachter weitergeleitet werden (Hintergrundbeleuchtung wie bei LCD Bildschirmen). Die Fläche erststreckt sich bevorzugt teilweise oder ganz durch Luft bzw. einen körperlosen Bereich. Dabei ist sie bevorzugt durch einen Rahmen oder eine Maske umrahmt. Besonders bevorzugt besteht die Fläche teilweise oder ganz aus einem zumindest teilweise oder zu einem bestimmten Grad oder komplett transparenten Festkörper oder verläuft teilweise oder ganz durch diesen. Z.B. sind die Leuchtflächen diejenigen Flächen der Anzeigevorrichtung welche die Subpixel darstellen und bei einem Leuchten der Subpixel das Licht an den Betrachter ausstrahlen. Die Form der Leuchtfläche ist beliebig, bevorzugt viereckig oder rund. Bevorzugt ist mindestens eine Leuchtflächenform in gleichmäßiger Wiederholung identisch vorhanden. Eine Leuchtfläche ist einem Pixel zugeordnet.

Unter einer nicht leuchtenden Fläche werden Bereiche verstanden, welche zwischen den Leuchtflächen vorhanden sind und welche von sich aus nicht leuchten oder hinterleuchtet sind. Bevorzugt ist eine oder sind alle nicht leuchtenden Flächen zu mindestens 90 % lichtundurchlässig.

Der Flächenschwerpunkt einer Leuchtfläche ist der geometrische Schwerpunkt oder Schwerpunkt der Fläche, welcher mathematisch der Mittelung aller Punkte innerhalb der Fläche entspricht.

Abstände, die kleiner sind als das Auflösungsvermögen eines Betrachters, sind bevorzugt derart, dass die Pixel oder Leuchtflächen so nahe zusammen angeordnet sind, dass ein Betrachter, dessen Augen sich bevorzugt in einem Abstand zu der Anzeigevorrichtung befinden, welcher für die konkrete Art der Anzeigevorrichtung bei der Benutzung der Anzeigevorrichtung üblich ist, zwei benachbarte Pixel oder Leuchtflächen nicht mehr voneinander unterscheiden kann.

Bevorzugt sind die Abstände, die kleiner sind als das Auflösungsvermögen des Betrachters, solche Abstände, die bei dem Betrachter unter einem Winkel von maximal zwei Winkelminuten erscheinen. Hierdurch sind die Pixel oder Leuchtflächen für einen Großteil der Betrachter nicht mehr unterscheidbar, da das menschliche Auflösungsvermögen in ungünstigen Fällen in etwa 2 Winkelminuten entspricht. Besonders bevorzugt erscheinen die Abstände dem Betrachter maximal unter einem Winkel von 1 Winkelminute, besonders bevorzugt 0,5 Winkelminuten, besonders bevorzugt 0,25 Winkelminuten. Hierdurch sind für nahezu alle menschlichen Betrachter die Pixel oder Leuchtflächen nicht mehr unterscheidbar. Je kleiner der maximale Winkel, desto weniger Betrachter existieren, deren Sehfähigkeit zur Unterscheidung zweier Pixel oder Leuchtflächen ausreicht.

Bevorzugt weist das oder weisen die Augen des Betrachters einen Abstand zu der Anzeigefläche auf, welche für die konkrete Art der Anzeigevorrichtung bei der Benutzung der Anzeigevorrichtung üblich ist. Zum Beispiel beträgt der Abstand 5 cm bis 1,20 m, bevorzugt 15 cm bis 60 cm für Displays von Handheldgeräten (Mobiltelefon, Uhr, Tablet-Computer), 25 cm bis 2 m, bevorzugt 40 cm bis 1 m für Displays von Desktop-Computer, 1 m bis 7 m bevorzugt 2 m bis 5 m für Fernsehgeräte und/oder 2 m bis 100 m, bevorzugt 5 m bis mehr als 100 m für Werbe-/Informationsanzeigetafeln. Besonders bevorzugt sind die Abstände, die kleiner als das Auflösungsvermögen des Betrachters sind, kleiner als 1 mm, wobei dies z.B. ein Abstand im Falle eines Fernsehers ist, bei dem der Benutzer in üblicher Betrachtungsentfernung (> 2m) die einzelnen Pixel oder Leuchtflächen dann nicht mehr voneinander unterscheiden kann.

Z.B. ist die Anzeigevorrichtung ein Desktop-Computer mit einer minimalen Nutzerdistanz (bezogen auf das Auge) von 50 cm. In der hypothetischen Annahme, dass z.B. 70% der potentiellen Benutzer über kein besseres Auflösungsvermögen als 0,6 Winkelminuten verfügen, werden die Pixel oder Leuchtflächen der Anzeigevorrichtung kleiner gleich 87 µm, bevorzugt 80 µm für einen Sicherheitspuffer, voneinander beabstandet, damit für zumindest 70% der Benutzer bei der üblichen Benutzung der Anzeigevorrichtung eine besonders hochwertige Darstellung ermöglicht wird, da für sie einzelne Leuchtflächen nicht unterscheidbar sind. Es resultiert eine Auflösung der Anzeigevorrichtung von 317 DPI, bevorzugt 320 DPI mit Sicherheitspuffer.

Erfindungsgemäß betragen die Abstände, die kleiner als das Auflösungsvermögen des Betrachters sind, maximal 190 µm, bevorzugt maximal 80 µm, besonders bevorzugt maximal 50 µm. Hierdurch wird erreicht, dass, auch wenn der Betrachter der Anzeigefläche näher als üblich kommt, er einzelne Pixel oder Leuchtflächen nicht voneinander unterscheiden kann. Je nach Auflösungsvermögen und Akkommodationsfähigkeit des individuellen Betrachters ist es damit sogar egal wie nahe der individuelle Betrachter der Anzeigevorrichtung kommt, denn er kann selbst bei optimaler Ausnutzung seiner Sehkraft und einem Annähern bis an die Naheinstellgrenze seines Auges nicht die einzelnen Pixel oder Leuchtflächen voneinander unterscheiden.

Bevorzugt beträgt die Ausdehnung einer, bevorzugt jeder, Leuchtfläche höchstens 70 µm, bevorzugt höchstens 25 µm, besonders bevorzugt höchstens 10 µm oder sogar höchstens 5 µm. Hierdurch wird erreicht, dass der Betrachter Leuchtflächen mit bloßem Auge (in ausgeschaltetem Zustand) nicht erkennen kann und der Kontrast höher wirkt. Die Ausdehnung ist bevorzugt eine Ausdehnung, bevorzugt die maximale Ausdehnung, einer Leuchtfläche parallel zur Anzeigefläche. Besonders bevorzugt ist die Ausdehnung kleiner oder gleich der Wellenlänge des sichtbaren und/oder des durchzuleitenden Lichts. Sie beträgt z.B. höchstens 2 µm, bevorzugt höchstens 1 µm oder höchstens 0,5 µm. Hierdurch ist insbesondere aufgrund des Rayleigh-Kriteriums der Austrittswinkel des von der Leuchtfläche ausgehenden Lichts größer.

Der Anteil der nicht leuchtenden Flächen an der gesamten Anzeigefläche ist bevorzugt der Anteil der Summe aller Flächenanteile der nicht leuchtenden Flächen am Flächeninhalt der Gesamtanzeigefläche. Er ist bevorzugt invers zum Anteil der Leuchtflächen an der Anzeigefläche, d.h. der Anteil der nicht leuchtenden Flächen und der Anteil der leuchtenden Flächen an der gesamten Anzeigefläche ergibt bevorzugt 100%.

Der Anteil von Leuchtflächen an der Anzeigefläche ist bevorzugt der Anteil der Summe aller Flächenanteile der Leuchtflächen an der gesamten Anzeigefläche.

Die nicht leuchtenden Flächen der Anzeigefläche ergeben sich bisher üblicherweise aufgrund von Verdrahtungen der Ansteuerung von LCD-Zellen und man ist im Stand der Technik bestrebt, diese übrigen Flächen möglichst zu minimieren, damit die Leuchtflächen so viel Platz als möglich erhalten.

Bevorzugt ist der Anteil der nicht leuchtenden Flächen an der gesamten Anzeigefläche größer als 80%, bevorzugt größer als 90%, besonders bevorzugt größer als 95%, ganz besonders bevorzugt größer als 98% und schließlich noch weiter bevorzugt mindestens 99%.

Bevorzugt ist analog dazu der Anteil der Leuchtflächen an der gesamten Anzeigefläche höchstens 20%, bevorzugt höchstens 10%, besonders bevorzugt höchstens 5%, ganz besonders bevorzugt höchstens 2% und schließlich noch weiter bevorzugt höchstens 1%. Je größer der Anteil der nicht leuchtenden Flächen und/oder je kleiner der Anteil der Leuchtflächen, desto stärker sind die eingangs erwähnten erfindungsgemäßen Effekte.

Bei einer weiteren Anzeigevorrichtung sind eine oder mehrere Leuchtflächen einem Pixel zugeordnet und die Anzeigefläche weist eine Vielzahl solcher Pixel auf, die in einem sich, bevorzugt gleichmäßig, wiederholenden Muster angeordnet sind, so dass aus den Pixeln Bilder zusammengesetzt werden können.

Bevorzugt weisen Leuchtflächen eines Pixels geringere gegenseitige Abstände auf als die Abstände zu Leuchtflächen eines anderen Pixels. Bevorzugt ist eine Leuchtfläche, besonders bevorzugt sind alle Leuchtflächen von anderen Leuchtflächen anderer Pixel getrennt, z.B. durch einen Bereich, der nicht leuchtfähig oder lichtleitfähig ist, d.h. durch nicht leuchtenden Flächen. Z.B. ist die Anzeigevorrichtung monochrom und die Pixel sind jeweils durch eine einzelne Leuchtfläche gebildet, oder die Anzeigevorrichtung ist polychrom und die Pixel sind jeweils durch zwei oder mehr Leuchtflächen gebildet, wobei die Leuchtflächen in unterschiedlichen Primärfarben leuchten oder die Pixel sind durch je eine Leuchtfläche gebildete, die polychrom leuchtet.

Bei einer weiteren Anzeigevorrichtung weist eine Mehrheit, bevorzugt alle, der nicht leuchtenden Flächen einen Reflexionsgrad diffuser Reflexion von weniger als 50 % auf.

Hierdurch werden die nicht leuchtenden Flächen vorteilhaft dazu genutzt, das Kontrastverhältnis positiv zu beeinflussen. Je weniger diffuse Reflexion auftritt, desto dunkler erscheinen die nicht leuchtenden Flächen. Ein entscheidender Vorteil dabei ist wiederum, dass man im Gegensatz zu üblichen Anzeigevorrichtungen eine viel größere Fläche zur Verfügung stehen hat (nämlich die gesamte Fläche aller nicht leuchtenden Flächen), um einen niedrigen Reflexionsgrad zu erzeugen, wobei dabei nicht darauf geachtet werden muss, dass die nicht leuchtenden Flächen transparent sein müssen oder Licht weiterleiten können, und somit einfacher und mit größerem Spielraum ein niedriger Reflexionsgrad erreicht werden kann (z.B. mittels Materialwahl, Oberflächenstruktur, Oberflächenbeschichtung etc.). Bevorzugt ist der Reflexionsgrad diffuser Reflexion weniger als 25 %, besonders bevorzugt weniger als 10 %, ganz besonders bevorzugt weniger als 5 % und noch weiter bevorzugt weniger als 1 %.

Im Gegensatz dazu, wird im Stand der Technik der Hintergrund der leuchtenden Flächen (OLED, LCD, LED, etc) mit sehr hohem Reflexionsgrad versehen, um so viel Licht wie möglich (mittels einer leuchtenden Fläche so groß wie möglich) nach vorne zu bringen. Das wirkt sich auf den Kontrast in dunkleren Bereichen negativ aus, insbesondere bei starkem Umgebungslicht, was wiederum zwingt die Lichtintensität zu erhöhen, um einen guten Kontrast gegenüber dam Umgebungslicht zu erzielen, was wiederrum mehr Energie kostet. Das ist wiederrum ein wesentlicher Nachteil für z.B. tragbare Geräte. Mit dieser Erfindung wird genau das Gegenteil angestrebt und erreicht (auch wenn der Hintergrund der minimalen leuchtenden Flächen mit einem sehr hohen Reflexionsgrad versehen sind). Ein Reflexionsgrad diffuser Reflexion ist bevorzugt als sog. Light Reflectance Value, LVR (bevorzugt gemäß dem britischen Messstandard BS8493:2008+A1:2010), besonders bevorzugt als Albedowert mittels eines Albedometers messbar, wobei bevorzugt eine Mehrheit, bevorzugt alle der nicht leuchtenden Flächen einen Albedo von weniger als 0,5, bevorzugt weniger als 0,25, besonders bevorzugt weniger als 0,10, ganz besonders bevorzugt weniger als 0,05 und noch weiter bevorzugt weniger als 0,01 aufweisen. Albedo ist dabei bevorzugt das Verhältnis des von einer vollen bestrahlten Fläche zum Beobachter gelangenden Strahlungsstroms zu dem, der von einer diffus reflektierenden, absolut wei-ßen Scheibe (ein sogenannter Lambertstrahler) gleicher Größe bei senkrechtem Lichteinfall zum Beobachter gelangen würde.

Bei einer weiteren erfindungsgemäßen Anzeigevorrichtung weist eine Mehrheit, bevorzugt alle, der nicht leuchtenden Flächen einen Reflexionsgrad spiegelnder Reflexion von weniger als 50 % auf.

Hierdurch werden die nicht leuchtenden Flächen vorteilhaft dazu genutzt, das Kontrastverhältnis positiv zu beeinflussen. Je weniger spiegelnde Reflexion auftritt, desto dunkler erscheinen die nicht leuchtenden Flächen, da sich hellere Objekte weniger an ihnen spiegeln. Zudem wird die Lesbarkeit erhöht, da ein Überblenden von ungleichmäßigen Spiegelbildern über das Anzeigebild reduziert wird. Ein entscheidender Vorteil dabei ist wiederum, dass man im Gegensatz zu üblichen Anzeigevorrichtungen eine viel größere Fläche zur Verfügung stehen hat, um einen niedrigen Reflexionsgrad zu erzeugen. Bevorzugt ist der Reflexionsgrad spiegelnder Reflexion weniger als 25 %, besonders bevorzugt weniger als 10 %, ganz besonders bevorzugt weniger als 5 % und noch weiter bevorzugt weniger als 1 %. Im Stand der Technik (herkömmliche Bildschirme) werden die (größeren) Leuchtenden Flächen meist mit Glas oder glasähnlichem Material versehen, und somit weist die gesamte Anzeigefläche einen größeren spiegelnden Reflexionsgrad auf. Im Gegensatz dazu basiert diese Erfindung auf sehr kleinen Leuchtflächen, so dass die Anzeigefläche deshalb kaum spiegelnde Reflexionen aufweist, auch wenn die Leuchtflächen mit Glas oder glasähnlichem Material versehen sind.

Ein Reflexionsgrad spiegelnder Reflexion ist bevorzugt in GU (gloss unit) mittels eines Glanzmessgeräts messbar, wobei bevorzugt eine Mehrheit, bevorzugt alle der nicht leuchtenden Flächen einen Glanz in GU von weniger als 50 GU, bevorzugt weniger als 25 GU, besonders bevorzugt weniger als 10 GU, ganz besonders bevorzugt weniger als 5 GU und noch weiter bevorzugt weniger als 1 GU aufweisen. Bevorzugt basiert die Skala für GU auf dem Referenzwert, der bei einem polierten, schwarzen Glas erreicht wird. Bei einer Kalibrierung wird dieser Referenzwert bevorzugt als 100 GU festgesetzt. Der zweite Referenzpunkt der Skala liegt bevorzugt bei 0 GU, dem Messwert, der bei einer perfekt matten Oberfläche erreicht wird.

Bei einer weiteren erfindungsgemäßen Anzeigevorrichtung weist die gesamte Anzeigefläche einen Reflexionsgrad diffuser Reflexion von weniger als 50 % und/oder einen Reflexionsgrad spiegelnder Reflexion von weniger als 50 % auf.

Dadurch, dass der Anteil der nicht leuchtenden Flächen an der Gesamtfläche dominiert, kann in einfacher Weise auch ein Reflexionsgrad (spiegelnd und/oder diffus) der gesamten Anzeigefläche effektiv reduziert werden und somit ein sehr gutes Kontrastverhältnis erhalten werden. Bevorzugt ist der Reflexionsgrad spiegelnder Reflexion der gesamten Anzeigefläche weniger als 25 %, besonders bevorzugt weniger als 10 %, ganz besonders bevorzugt weniger als 5 % und noch weiter bevorzugt weniger als 1 %. Bevorzugt ist der Reflexionsgrad diffuser Reflexion der gesamten Anzeigefläche weniger als 25 %, besonders bevorzugt weniger als 10 %, ganz besonders bevorzugt weniger als 5 % und noch weiter bevorzugt weniger als 1 %.

Bei einer weiteren erfindungsgemäßen Anzeigevorrichtung weist eine Mehrheit, bevorzugt alle, der nicht leuchtenden Flächen eine dunkle Farbe auf oder ist schwarz.

Hierdurch wird ein niedriger Reflexionsgrad insbesondere der diffusen Reflexion erreicht.

Eine dunkle Farbe ist bevorzugt eine Farbe in einem RGB-Farbraum (z.B. sRGB oder Adobe RGB 1998), deren Mittelwert aus R-Wert, G-Wert und B-Wert kleiner oder gleich als 25% des Maximalwerts ist, d.h. z.B. bei einem Maximalwert von 255 (je R,G,B 256 Stufen) ist der Mittelwert kleiner als 63,75 ist.

Besonders bevorzugt ist eine dunkle Farbe eine der Pantonefarben: 1545, 1545 C, 161, 161 C, 168, 1815, 1817, 2617 C, 262, 2627, 2627 C, 2685 C, 2695 C, 273 C, 2735 C, 2738, 2738 C, 274, 274 C, 2745, 2745 C, 2747, 2747 C, 2748, 2748 C, 275, 275 C, 2755, 2755 C, 2756 C, 2757, 2757 C, 2758, 2758 C, 276, 276 C, 2765, 2765 C, 2766, 2766 C, 2767, 2767 C, 2768, 2768 C, 280, 280 C, 281, 281 C, 282, 282 C, 287 C, 288, 288 C, 289, 289 C, 294 C, 295, 295 C, 2955, 2955 C, 296, 296 C, 2965, 2965 C, 302, 302 C, 3025, 303, 303 C, 3035, 3035 C, 309, 309 C, 316, 316 C, 3165, 3165 C, 3292, 3292 C, 3298 C, 330, 330 C, 3302, 3302 C, 3305, 3305 C, 3308, 3308 C, 336, 336 C, 342, 342 C, 3425, 3425 C, 343, 343 C, 3435, 3435 C, 349, 349 C, 350, 350 C, 356, 356 C, 357, 357 C, 368 2X, 412, 412 C, 419, 419 C, 426, 426 C, 432 C, 433, 433 2X, 433 C, 439, 439 C, 440, 440 C, 447, 447 C, 448 C, 4485, 4625, 4625 C, 469, 4695, 4695 C, 476 C, 483, 483 C, 490, 490 C, 497, 497 C, 4975, 4975 C, 504, 504 C, 505, 5115, 5115 C, 5185, 5185 C, 5255, 5255 C, 532, 532 C, 533 C, 534 C, 539, 539 C, 5395, 5395 C, 540, 540 C, 541, 541 C, 546, 546 C, 5463, 5463 C, 5467, 5467 C, 547, 547 C, 548, 548 C, 553, 553 C, 5535, 5535 C, 554, 554 C, 560, 560 C, 5605, 5605 C, 561 C, 567 C, 5743 C, 5747 C, 5753, 5757, 5815, 626, 627, 627 C, 648, 648 C, 654, 654 C, 655, 655 C, 662, 662 C, 669 C, 725, 731, 732, 732 C, 7421 C, 7449 C, 7463 C, 7476 C, 7483 C, 7484 C, 7533 C, 7546 C, 7547 C, 7554 C, 7631 C, 7645 C, 7693 C, 7694 C, 7720 C, 7721 C, 7722 C, 7727 C, 7728 C, 7729 C, 7732 C, 7733 C, Black, Black 2, Black 2 2X, Black 2 C, Black 3, Black 3 2X, Black 3 C, Black 4, Black 4 2X, Black 4 C, Black 5, Black 5 2X, Black 5 C, Black 6, Black 6 2X, Black 6 C, Black 7, Black 7 2X, Black 7 C, Black C, Blue 072 C, Dark Blue C, Neutral Black C, Reflex Blue, Reflex Blue 2X, Reflex Blue C.

Bei einer weiteren erfindungsgemäßen Anzeigevorrichtung weist eine Mehrheit, bevorzugt alle, der nicht leuchtenden Flächen einen Mittenrauwert im Bereich von 0,2 µm und 1,0 µm auf.

Hierdurch werden insbesondere spiegelnde Reflexionen im Bereich der Wellenlängen des sichtbaren Lichts reduziert. Bevorzugt liegt der Mittenrauwert im Bereich von 0,4 µm - 0,8 µm. Bevorzugt wird zur Ermittlung dieses Messwertes die Oberfläche auf einer definierten Messstrecke abgetastet und sämtliche Höhen- und Tiefenunterschiede der rauen Oberfläche werden aufgezeichnet. Nach der Berechnung des bestimmten Integrals dieses Rauheitsverlaufes auf der Messstrecke wird abschließend dieses Ergebnis durch die Länge der Messstrecke dividiert.

Bei einer weiteren erfindungsgemäßen Anzeigevorrichtung sind eine Mehrheit, bevorzugt alle, der nicht leuchtenden Flächen mittels einer Antireflexbeschichtung beschichtet.

Hierdurch werden ebenfalls insbesondere spiegelnde Reflexionen reduziert. Eine Antireflexbeschichtung ist bevorzugt eine Entspiegelungsfolie (z.B. 3M^{™} Vikuiti^{™}) oder eine Entspiegelungsbeschichtung. Die Antireflexbeschichtung weist bevorzugt eine raue Oberfläche auf (z.B. mit Mittenrauwert im Bereich von 0,2 µm bis 1,0 µm) und/oder Entspiegelungsschichten basierend auf destruktiver Interferenz auf.

Bei einer weiteren erfindungsgemäßen Anzeigevorrichtung weist die Anzeigevorrichtung eine elektronische Kompensationseinrichtung auf, mittels welcher eine minimale Helligkeit der Leuchtflächen für die Anpassung der Darstellung schwarzer Bildpixel in Abhängigkeit der Umgebungshelligkeit automatisch einstellbar ist.

Hierdurch ist das Kontrastverhältnis an die Umgebungshelligkeit anpassbar. Auch wenn die nicht leuchtenden Flächen möglichst dunkel und nicht reflektierend ausgestaltet sind, wird die Helligkeit der nicht leuchtenden Flächen je nach Umgebungshelligkeit heller oder dunkler sein. Mittels der Kompensationseinrichtung kann die minimale Helligkeit der Leuchtflächen nun jedoch auch entsprechend an die Helligkeit der nicht leuchtenden Flächen angepasst werden. Ein schwarzer Bildpixel ist ein solcher, der z.B. als RBG Bildinformation (0, 0, 0) enthält. Mittels der Kompensationseinrichtung wird dieser Schwarzpunkt an die Umgebungshelligkeit angepasst, d.h. z.B. wird er bei größerer Umgebungshelligkeit erhöht und bei niedrigerer Umgebungshelligkeit reduziert. Z.B. wird bei hoher Sonneneinstrahlung ein schwarzer Bildpunkt nicht durch komplett ausgeschaltete Leuchtflächen dargestellt, sondern die Leuchtflächen werden mit einer Helligkeit angesteuert, so dass die Leuchtflächen in etwa dieselbe Helligkeit wie die nicht leuchtenden Flächen aufweisen. Die übrigen Helligkeitsstufen des anzuzeigenden Bilds werden dann auf den verbleibenden Bereich zwischen der durch die Kompensationseinrichtung eingestellten minimalen Helligkeit und der maximalen Helligkeit der Leuchtflächen verteilt. Auf diese Weise "versinkt" der dunkle Bildanteil nicht. Bevorzugt weist die elektronische Kompensationseinrichtung einen Umgebungslichtsensor auf.

Im weiteren Verlauf der Beschreibung werden unter anderem auch Lichtquellen genannt. Diese und deren Zusammenhang mit den Leuchtflächen werden vorgreiflich global beschrieben.

Eine Lichtquelle ist bevorzugt eine steuerbare, Lichtquelle, wobei das von der Lichtquelle ausgesendete Licht zumindest an- und ausschaltbar ist, bevorzugt ist jedoch die Intensität des ausgesendeten Lichts in mehreren Stufen oder kontinuierlich modulierbar. Sie ist z.B. eine aktive Lichtquelle wie eine LED (OLED, Mikro-LED), ein Laser (z.B. ein VCSEL bzw. Oberflächenemitter), bevorzugt mit einem Strahldurchmesser von 5 µm oder weniger, oder eine Plasmazelle. Damit sind sehr kleine und energieeffiziente Lichtquellen möglich. Eine Lichtquelle kann auch eine UV-LED oder blaue LED, die mit einer Leuchtstoffschicht zusammenwirkt, oder ein Elektronen-Emitter, der mit einer Leuchtsotffschicht zusammenwirkt, sein. Die maximale Ausdehnung einer leuchtaktiven Fläche (d.h. aktive Leuchtfläche) der Lichtquelle (z.B. die Fläche des pn-Übergangs) oder eines von der Lichtquelle erzeugten Laserstrahls parallel zur Anzeigefläche ist bevorzugt kleiner oder gleich der maximalen Ausdehnung der Leuchtfläche, d.h. z.B. höchstens 70 µm, bevorzugt höchstens 25 µm, besonders bevorzugt höchstens 10 µm oder 5 µm oder noch geringer z.B. 2 µm, 1 µm oder 0,5 µm. Bevorzugt weist die Leuchtfläche ein Streuelement auf, insbesondere dann, wenn die maximale Ausdehnung des von der Lichtquelle erzeugten Strahls, insbesondere Laserstrahls, kleiner als die maximale Ausdehnung der Leuchtfläche ist. Bevorzugt sind die Lichtquellen Elemente eines Lichtquellenarrays oder Pixel oder Subpixel eines als Beleuchtungseinrichtung in die Anzeigevorrichtung integrierten und hinter den Beleuchtungsflächen angeordneten Displays, insbesondere OLED-Displays. Z.B. ist einer Leuchtfläche ein Pixel- und/oder Subpixel-Array eines Displays zugeordnet, z.B. 1x2, 2x2, 4x4, 5x5, 10x10 oder 100x100 Pixel oder Subpixel.

Bevorzugt ist mindestens eine der Lichtquellen, bevorzugt jede Lichtquelle, eine dichromatische, bevorzugt polychromatische Lichtquelle oder es sind unterschiedliche Lichtquellen mit verschiedenen Emissionswellenlängen vorhanden. Hierdurch ist eine zwei- oder mehr- bzw. vollfarbige Darstellung mittels der Anzeigevorrichtung möglich. Monochromatisch bedeutet bevorzugt, dass die Lichtquelle im wesentlichen in einem bestimmten, bevorzugt gleichbleibendem Wellenlängenbereich oder Wellenlängenmix Licht emittiert (z.B. Rot), dichromatisch bedeutet bevorzugt, dass die Lichtquelle eingerichtet ist, steuerbar in zwei verschiedenen Wellenlängenbereichen Licht zu emittieren (z.B. ein jeweils steuerbarer Grün- und Rot-Anteil), polychromatisch bedeutet bevorzugt dass die Lichtquelle eingerichtet ist, steuerbar in zwei oder mehr verschiedenen Wellenlängenbereichen Licht zu emittieren (z.B. ein jeweils steuerbarer Grün- und Rot- und Blau-Anteil).

Bevorzugt ist jeder Leuchtfläche genau eine polychromatische Lichtquelle zugeordnet. Hierdurch ist eine Zuordnung der Lichtquellen zu den Leuchtflächen gegeben, wodurch eine Einzelmodulation der Lichtquellen möglich ist und somit unterscheidet sich diese Ausführungsform z.B. von einem im Energieverbrauch schlechteren LCD, bei dem großflächig Licht erzeugt wird, und dann jedoch lokal wieder abdunkelt werden muss. Anstatt dieses räumlich subtraktiven Bildaufbaus wird bevorzugt ein räumlich additiver Bildaufbau ermöglicht. Unterschiedlich monochromatische Lichtquellen sind z.B. solche, die jeweils für sich in einem Wellenbereich abstrahlen, die Wellenlängenbereiche der einzelnen Lichtquellen unterscheiden sich jedoch (z.B. Rot, Grün, Blau). Gleich monochromatische Lichtquellen sind z.B. solche, die alle jeweils im wesentlich gleichen Wellenbereich abstrahlen. Alternativ sind mehrere Leuchtflächen einer oder mehreren monochromatischen Lichtquellen, bevorzugt polychromatischen Lichtquellen zugeordnet. Bevorzugt ist dabei ein Pixel durch mehrere Leuchtflächen gebildet, denen Lichtquellen unterschiedlicher Wellenlängen zugeordnet sind. Z.B. ist ein Pixel durch drei oder mehr Leuchtflächen gebildet, wobei zumindest einer Leuchtfläche eine oder mehrere Lichtquellen zugeordnet sind, die grünes Licht zur Leuchtfläche ausstrahlen, zumindest einer zweiten Leuchtfläche eine oder mehrere Lichtquellen zugeordnet sind, die blaues Licht zur zweiten Leuchtfläche ausstrahlen, und zumindest einer dritten Leuchtfläche eine oder mehrere Lichtquellen zugeordnet sind, die rotes Licht zur dritten Leuchtfläche ausstrahlen. Bevorzugt existiert je ein Lichtpfad zu je einer der Leuchtflächen für mehrere monochromatische Lichtquellen. Alternativ existiert je ein Lichtpfad zu je einer der Leuchtflächen für eine oder mehrere polychromatische Lichtquellen. Bevorzugt ist dabei ein nicht-abbildendes optisches Element, z.B. ein Streuelement, für eine vorteilhafte Homogenisierung der polychromatischen Lichtquellen vorhanden.

Erfindungsgemäß weist die Anzeigevorrichtung eine Beleuchtungseinrichtung mit einem Substrat auf, auf dem mehrere Lichtquellen angeordnet sind.

Hierdurch ist in einfacher Weise eine Anzeigevorrichtung mit einer erfindungsgemäßen Anzeigefläche realisierbar.

Die Beleuchtungseinrichtung ist bevorzugt von dem Betrachter aus hinter den Leuchtflächen angeordnet und eingerichtet, die Leuchtflächen von hinten zu beleuchten, das heißt von deren Rückseite. Die Rückseite ist die dem Betrachter abgewandte Seite einer Leuchtfläche.

Die Beleuchtungseinrichtung weist bevorzugt eine oder mehrere aktive Lichtquellen auf oder passive Lichtquellen, wie z.B. Umlenkspiegel, welche Licht von einer anderen Lichtquelle, was zum Beispiel auch Umgebungslicht, insbesondere Tages- bzw. Sonnenlicht darstellen kann, auf die Leuchtflächen von hinten leiten.

Der Abstand zwischen den Leuchtflächen und der Beleuchtungseinrichtung (z.B. gemessen ab einer lichtemittierenden oder -reflektierenden Fläche der Beleuchtungseinrichtung, welche Licht bereits im Wesentlichen parallel zur Betrachtungsrichtung aussendet oder weiterleitet) beträgt bevorzugt höchstens 3 mm, besonders bevorzugt höchstens 1 mm, ganz besonders bevorzugt höchstens 0,5 mm oder noch bevorzugter höchstens 0,2 mm.

Das Substrat ist bevorzugt eine ebene Platte, z.B. eine Platine oder ein Waver.

Eine mögliche Realisierung von Lichtquellen sieht zum Beispiel Laser mit z.B. 5 µm Strahldurchmesser vor, die auf einem Substrat (wie zum Beispiel einem Si-Waver) als Array angeordnet sind, z.B. in Form eines Quadrats mit z.B. 50 µm Kantenlänge. Bevorzugt ist über einem solchen Quadrat ein Streuelement angeordnet, welches auch gleichzeitig die Leuchtfläche bildet. Die einzelnen Laser in einem Quadrat weisen bevorzugt voneinander verschiedene Emissionswellenlängen auf. Viele solche Einheiten bilden dann Pixel oder Subpixel der Anzeigevorrichtung.

Bei einer weiteren erfindungsgemäßen Anzeigevorrichtung sind die Leuchtflächen jeweils durch eine der Lichtquellen oder durch ein von einer der Lichtquellen beleuchtbares optisches Streuelement oder transparentes Abdeckelement oder optisches Farbfilterelement gebildet und die nicht leuchtenden Flächen der Anzeigefläche sind durch Flächen des Substrats und/oder durch Flächen eines Füllmaterials zwischen den Leuchtflächen gebildet.

Durch diese bevorzugte Ausgestaltung der Leuchtflächen und Zuordnung zu den Lichtquellen ist eine besonders effiziente Bilddarstellung möglich. Durch die Ausgestaltung der nicht leuchten Flächen aus Substratmaterial oder Füllmaterial sind insbesondere die reflektierenden Eigenschaften der nicht leuchtenden Flächen sehr gut einstellbar. Das Füllmaterial ist bevorzugt ein gießbares Material oder es ist mittels eines 3D-Druckverfahrens zwischen den Lichtquellen aufgebaut oder ein in der Form her anpassbare Material (rund um die leuchtenden Flächen) oder ein Material, das die leuchtenden Flächen durchscheinen lässt (transparent und/oder engmaschig und/oder gelöchert).

Ein optisches Streuelement ist bevorzugt ein Körper, welcher Licht, welches aus einer Richtung auf das Streuelement auftrifft, in mehr als zwei verschiedene, bevorzugt in eine Vielzahl verschiedener Richtung weiterleitet, sei es transmissiv und/oder reflektiv. Z.B ist das optische Streuelement ein semi-transparenter und/oder matter Körper (Milchglaskörper) aus Glas oder Plastik, bevorzugt mit eingelassenen Streupartikeln (z.B. Silberpartikel oder Nanopartikel), ein Mikroprisma, Mattfilm zum Aufkleben, eine winzige Mattscheibe oder eine diffraktive Optik, z.B. ein Gitter. Das Streuelement ist bevorzugt eingerichtet, (annähernd) als Lambertstrahler zu dienen, z.B. so dass eine gleichmäßig Abstrahlung innerhalb eines großen Raumwinkels, z.B. 180°, erfolgt. Bevorzugt ist es eingerichtet gemäß dem Rayleigh-Effekt zu streuen und/oder gemäß dem Plasmonic-Effekt. Z.B bedeutet das, dass das Streuelement Öffnungen aufweist, welche kleiner als die Wellenlänge des sichtbaren und/oder durchzuleitenden Lichts sind (z.B. 1 µm oder kleiner). Bevorzugt ist, z.B. in diesem Fall, die Leuchtfläche durch eine nicht-transparente Maske (z.B. eine später noch beschriebene Abdeckschicht) oder einen Rahmen umrahmt, und die Ausdehung der Leuchtfläche ist z.B. kleiner, als die Wellenlänge des sichtbaren und/oder des durchzuleitenden Lichts, so dass allein durch die Größe der Leuchtfläche in Kombination einer Umrahmung ein Streuelement geben ist.

Bei einer weiteren erfindungsgemäßen Anzeigevorrichtung weist jede Lichtquelle einen Elektronen-Emitter auf, welcher eingerichtet ist, durch Aussendung eines Elektronenstrahls eine Leuchtstoffschicht zum aktiven Leuchten zu bringen, oder jede Lichtquelle weist einen UV-Emitter auf, welcher eingerichtet ist, durch Aussendung eines UV-Lichtstrahls die Leuchtstoffschicht zum aktiven Leuchten zu bringen.

Auf diese Weise sind sehr effiziente und spektral gut justierbare Lichtquellen realisiert. Insbesondere können durch die erfindungsgemäßen Flächenverhältnisse von nicht leuchtenden Flächen und Leuchtflächen die UV-Emitter und insbesondere die Elektronenemitter besser gegenseitig voneinander getrennt werden, was besonders bei Elektronenemittern, die jeweils eine eigene Vakuumzelle benötigen, besonders vorteilhaft ist. Unter UV-Emitter wird auch bevorzugt ein Emitter, der im blauen bis violetten Bereich (mit oder ohne UV-Bereich) abstrahlt, verstanden. Bei Elektronenemittern ist Vakuum notwendig und den Abstand zwischen den Leuchtflächen dieser Erfindung kann somit dazu benutzt werden um Abstandhalter einzubauen, was im Stand der Technik sehr schwierig ist, weil die leuchtenden Flächen sehr groß sind bzw. so groß wie möglich sind und Abstandhalter störend (z.B. Schattenwurf) wirken.

Bei einer weiteren erfindungsgemäßen Anzeigevorrichtung weist die Anzeigevorrichtung eine Beleuchtungseinrichtung mit einer Lichtquelle oder mit mehreren Lichtquellen auf und die aktive Leuchtfläche der Lichtquelle oder, wenn die Beleuchtungseinrichtung mehrere Lichtquellen aufweist, jeweils die aktiven Leuchtflächen der Lichtquellen weisen einen Flächeninhalt auf, der größer als die Flächeninhalte der Leuchtflächen der Anzeigefläche ist.

Hierdurch ist eine Erzeugung des Lichts auf einer größeren Fläche als die Größe der Leuchtflächen möglich, und somit ist, bevorzugt mit zusätzlicher Konzentration des Lichts auf die kleineren Leuchtflächen, eine höhere Strahlungsdichte innerhalb der Leuchtflächen erreichbar. Bevorzugt ist die Fläche der Beleuchtungseinrichtung oder die Summe der Flächen der Beleuchtungseinrichtung, welche Licht emittieren, größer als die Summe aller Flächeninhalte der Leuchtflächen. Bevorzugt ist die Gesamtausdehnung aller einer Leuchtfläche zugeordneten Lichtquellen größer als die Ausdehnung der Leuchtfläche. Bevorzugt sind die Lichtquellen polychromatisch und die Lichtquellen bzw. deren aktive Leuchtflächen weisen eine Ausdehnung auf, die mehr als 50%, bevorzugt mehr als 75% des Abstands der Flächenschwerpunkte der Leuchtflächen beträgt. Bevorzugt sind die Lichtquellen monochromatisch und die Lichtquellen bzw. deren aktive Leuchtflächen weisen eine Ausdehnung auf, die mehr als 50%, bevorzugt mehr als 75%, eines Drittels des Abstands der Flächenschwerpunkte der Leuchtflächen beträgt. Die aktive Leuchtfläche der Lichtquelle ist diejenige Fläche, welche aktiv leuchtet (z.B. die Fläche eines pn-Übergangs).

Bei einer weiteren erfindungsgemäßen Anzeigevorrichtung sind die Leuchtflächen jeweils durch ein von der Beleuchtungseinrichtung beleuchtbares optisches Streuelement oder transparentes Abdeckelement oder optisches Farbfilterelement gebildet und die nicht leuchtenden Flächen der Anzeigefläche sind durch Flächen eines zwischen den Leuchtflächen angeordneten Füllmaterials oder Substrats gebildet.

Durch diese bevorzugte Ausgestaltung der Leuchtflächen und Zuordnung zu der Beleuchtungseinrichtung ist wiederum eine besonders effiziente Bilddarstellung möglich. Durch die Ausgestaltung der nicht leuchten Flächen aus Substratmaterial oder Füllmaterial sind insbesondere die reflektierenden Eigenschaften der nicht leuchtenden Flächen sehr gut einstellbar. Das Streuelement ist bevorzugt ein wie zuvor detaillierter beschriebenes Streuelement.

Erfindungsgemäß weist die Anzeigevorrichtung optische Strahlformeinrichtungen auf, die zwischen der Beleuchtungseinrichtung und der Anzeigefläche angeordnet sind, und jeder Strahlformeinrichtung ist eine Leuchtfläche zugeordnet und die Strahlformeinrichtungen sind jeweils eingerichtet, Licht von der Beleuchtungseinrichtung auf die jeweilige Leuchtfläche zu konzentrieren.

Hierdurch kann Licht auf die Leuchtflächen mittels einer Strahlformung konzentriert werden, wodurch die maximal erreichbare Helligkeit erhöht wird. Die optischen Strahlformelemente sind bevorzugt eingerichtet, Licht aus der Beleuchtungseinrichtung auf eine Leuchtfläche zu konzentrieren und/oder zu fokussieren. Bevorzugt weisen eine oder mehrere Strahlformeinrichtungen am Ausgang eine Spitze oder ein rohrförmiges oder zylindrisches Endstück (sozusagen ein "Lightguide"), z.B. ein Glasfaserstück auf, besonders bevorzugt mit einer abschließenden Diffusionsschicht.

Ein Strahlformelement ist bevorzugt dann einer Leuchtfläche zugeordnet, wenn Licht aus dem Strahlformelement kommend durch die Leuchtfläche propagiert. Die Ausdehnung der Strahlformelemente entlang der optischen Achse beträgt bevorzugt weniger als 3 mm, besonders bevorzugt weniger als 1 mm, ganz besonders bevorzugt weniger als 0,5 mm oder noch bevorzugter weniger als 0,25 mm. Die Strahlformelemente sind bevorzugt gegossen oder mittels Laserlithographie hergestellt. Bevorzugt bilden sie ein Array aus Strahlformelementen. Bevorzugt ist jedem optischen Strahlformelement mindestens eine Lichtquelle der Beleuchtungseinrichtung zugeordnet.

Durch die Lichtkonzentration der Strahlformeinrichtung (z.B. mittels einer Linse oder einem Lightguide, z.B. eine Glasfaser) ist eine Überbrückung des Abstands zwischen den Lichtquellen und den Leuchtflächen sehr effizient möglich. Bevorzugt weist die Strahlformeinrichtung eine Ausdehnung in Richtung entlang der Anzeigefläche oder des Substrats auf, die größer ist als die einer Lichtquelle, besonders bevorzugt ist die Ausdehnung so groß wie der Abstand der Flächenschwerpunkte benachbarter Leuchtflächen.

Bei einer weiteren erfindungsgemäßen Anzeigevorrichtung weisen die optischen Strahlformeinrichtungen jeweils einen optischen Kollimator auf.

Hierdurch kann das Licht der Lichtquelle eingesammelt und in eine Richtung gelenkt werden. Als Kollimator sind z.B. eine Kollimatorfolie (Mikroprismenfolie, Mikropyramidenfolie, Microspherefolie) und/oder ein (Parabol-/Ellipsen-)Reflektor mit der Lichtquelle bevorzugt im Brennpunkt und/oder (Mikro-)Linsen (Fresnel oder herkömmlich) vorgesehen oder allgemein eine kollimierende reflektive oder transmissive Optik. Ein Kollimator ist bevorzugt eingerichtet, den Abstrahlwinkel einer Lichtquelle der Beleuchtungseinrichtung über Strahlumlenkung zur optischen Achse hin zu verringern.

Erfindungsgemäß weisen die optischen Strahlformeinrichtungen jeweils einen optischen Konzentrator auf.

Durch diesen Teil der Strahlformeinrichtung wird das Licht auf die Leuchtfläche effektiv konzentriert. Als Konzentrator ist z.B. ein (üblicherweise nicht abbildender) Compound Parabolic Conentrator (CPC) vorgesehen und/oder photonische Kristalle oder allgemein eine fokussierende oder konzentrierende reflektive oder transmissive Optik wie z.B. auch eine (abbildende oder nicht abbildende) Kondensor- oder Fresnellinse. Bevorzugt ist der Konzentrator eine nicht abbildende Optik, wodurch eine höhere Effizienz der Konzentration und eine Intensitätshomogenisierung erreichbar ist. Der der Beleuchtungseinrichtung zugewandte Eingang des optischen Konzentrators weist bevorzugt eine größere Fläche auf (z.B. im Durchmesser oder in der Diagonale 80 µm) als der einer Leuchtfläche zugewandte Ausgang des optischen Konzentrators (z.B. im Durchmesser oder in der Diagonale 8 µm). Dies gilt bevorzugt für jeden optischen Konzentrator. Bevorzugt weist der Eingang eine Fläche auf, die so groß und gleichermaßen geformt ist, wie die lichtemittierenden Flächen der dem Konzentrator zugeordneten Lichtquelle oder Lichtquellen. Hierdurch wird Licht von einer größeren Eintrittsfläche auf eine kleine Leuchtfläche konzentriert. Bevorzugt weist der Konzentrator einen Eingang und einen Ausgang auf. Bevorzugt weist der Eingang eine größere Fläche auf als der Ausgang. Bevorzugt ist der Ausgang der Leuchtfläche sowie der Anzeigefläche zugewandt und der Eingang ist der Beleuchtungseinrichtung zugewandt. Der Konzentrator weist bevorzugt einen optischen Eingangswinkel auf, welcher maximal um 30°, bevorzugt maximal um 10° kleiner ist, als der optische Ausgangswinkel des Kollimators. Besonders bevorzugt ist der optische Eingangswinkel des Konzentrators gleich oder größer als der Ausgangswinkel des Kollimators.

Bei einer weiteren erfindungsgemäßen Anzeigevorrichtung ist der optische Kollimator bezüglich einer Propagationsrichtung des Lichts der Beleuchtungseinrichtung vor dem Konzentrator angeordnet, so dass Licht zunächst im wesentlichen kollimierbar und dann konzentrierbar ist.

Hierdurch ist eine besonders effektive Strahlformung möglich. Besonders bevorzugt sind optischer Kollimator und optischer Konzentrator in einem Element vereint. Hierdurch können Streulichtverluste minimiert werden.

Erfindungsgemäß weisen die optischen Strahlformeinrichtungen mindestens eine gekrümmte oder abgestufte Reflektorfläche auf. Durch gekrümmte oder abgestufte Reflektorflächen ist das Licht mit einem enorm erhöhten Wirkungsgrad auf die Leuchtflächen leitbar, insbesondere durch Ausnutzen des Phänomens der Totalreflexion. Bevorzugt handelt es sich um parabolisch oder elliptisch gekrümmte Flächen (z.B. eines CPC) oder um einem Facettenspiegel.

Die Erfindung soll nun anhand von Zeichnungen beispielhaft weiter veranschaulicht werden. Hierbei zeigen:
- **Fig. 1**: einen vergrößerten Ausschnitt einer Anzeigevorrichtung, bei welcher der Anteil von nicht leuchtenden Flächen an der Anzeigefläche mehr als 70% beträgt,
- **Fig. 2**: eine rein qualitative Veranschaulichung eines Abstands, der kleiner ist als das Auflösungsvermögen des Betrachters und der bei dem Betrachter unter einem Winkel von maximal zwei Winkelminuten erscheint,
- **Fig. 3a und 3b**: Ausschnitte von Anzeigevorrichtungen aufbauend auf Fig. 1 wobei die Anzeigevorrichtung eine Farbanzeigevorrichtung ist,
- **Fig. 4a bis 6d,**: wie auf verschiedene Weise die zweidimensionale Struktur einer Anzeigefläche gemäß dem Prinzip, einen Anteil von nicht leuchtenden Flächen an der gesamten Anzeigefläche von mehr als 70% vorzusehen, erhalten werden kann, wobei

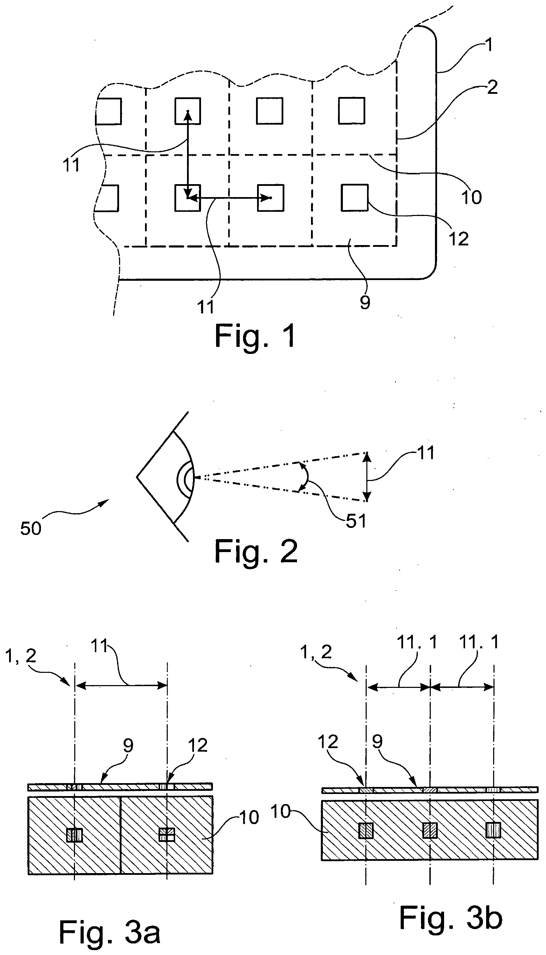

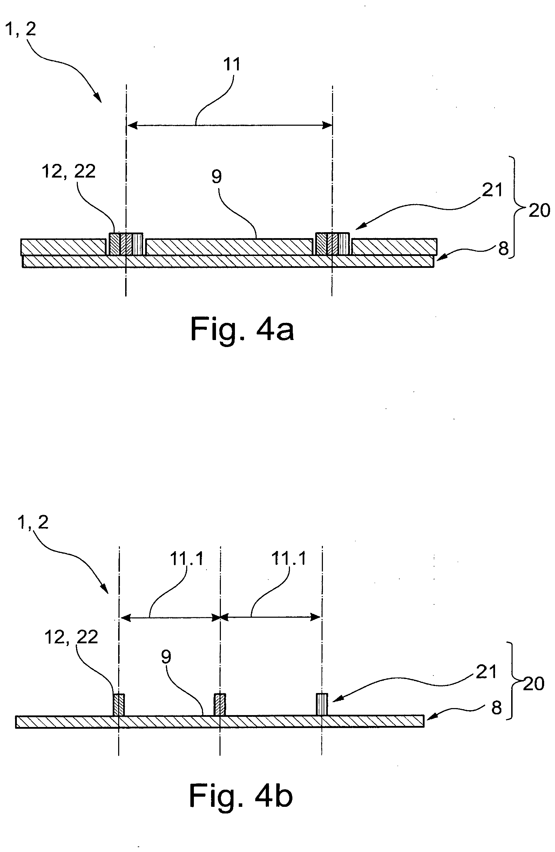

- **Fig. 4a bis 4e**: Ausschnitte von Anzeigevorrichtungen aufbauend auf Fig. 3a oder 3b zeigen, wobei die Anzeigevorrichtung eine Beleuchtungseinrichtung mit einem Substrat aufweist, auf dem mehrere Lichtquellen angeordnet sind, wobei dabei bevorzugt die Lichtquellen kleine Lichtquellen sind (z.B. VCSEL-Laser), d.h. bevorzugt Lichtquellen, bei denen der Flächeninhalt der aktiven Leuchtfläche kleiner oder gleich dem Flächeninhalt der entsprechenden Leuchtfläche ist, und wobei

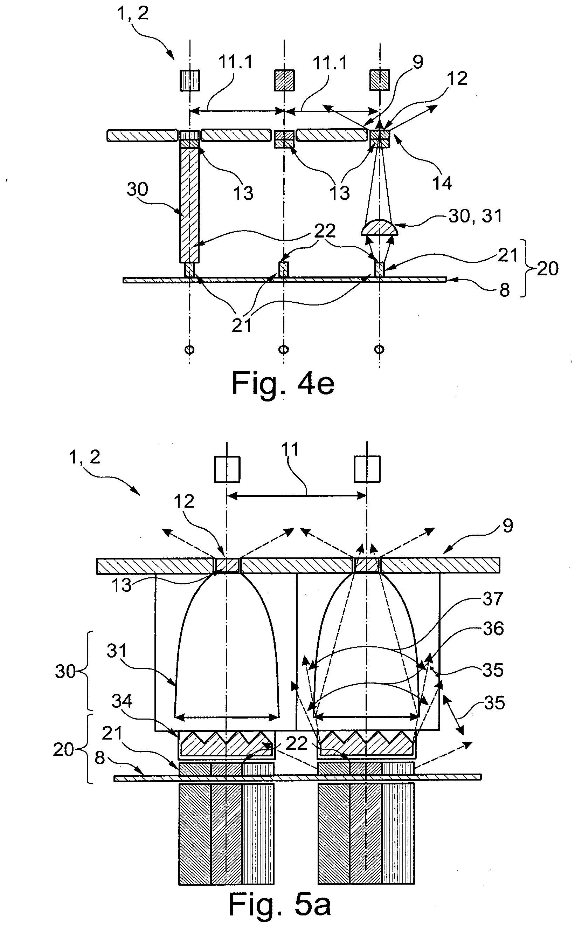

- **Fig. 5a bis 6d**: Ausschnitte erfindungsgemäßer Anzeigevorrichtungen aufbauend auf Fig. 3a oder 3b zeigen, wobei diese im Vergleich zu Fig. 4a-4e größere Lichtquellen aufweisen und insbesondere jeweils optische Strahlformeinrichtungen, die zwischen der Beleuchtungseinrichtung und der Anzeigefläche angeordnet sind, und wobei jeder Strahlformeinrichtung eine Leuchtfläche zugeordnet ist und die Strahlformeinrichtungen jeweils eingerichtet sind, Licht von der Beleuchtungseinrichtung auf die jeweilige Leuchtfläche zu konzentrieren.

**Fig. 1** zeigt einen vergrößerten Ausschnitt einer Anzeigevorrichtung, 1 bei welcher der Anteil von nicht leuchtenden Flächen 9 an der gesamten Anzeigefläche 2 mehr als 70% beträgt. Die Anzeigevorrichtung 1 weist eine Anzeigefläche 2 (Grenze = gestrichelte Linie mit den längsten Strichen) auf, die aus nicht leuchtenden Flächen 9 und Leuchtflächen 12 besteht. Die Flächenschwerpunkte benachbarter Leuchtflächen 12 weisen gegenseitige Abstände 11 auf, die kleiner sind, als das Auflösungsvermögen eines Betrachters. Dieses Beispiel zeigt außerdem, dass eine oder mehrere Leuchtflächen 12 einem Pixel 10 (Pixelgrenze = gestrichelte Linie mit mittlerer Strichlänge) zugeordnet sind und die Anzeigefläche 2 eine Vielzahl solcher Pixel 10 aufweist, die in einem sich wiederholenden Muster angeordnet sind, so dass aus den Pixeln 10 Bilder zusammengesetzt werden können.

Ein sehr großer Vorteil besteht darin, dass die Leuchtflächen 12 durch große Trennbereiche, die durch nicht leuchtende Flächen 9 gebildet sind, voneinander getrennt sind und sich somit einerseits kein Streuleuchten von einer auf die andere Leuchtfläche 12 ergibt (oder dieses stark reduziert wird) und dass andererseits dunkle Bereiche eines durch die Anzeigevorrichtung 1 dargestellten Bilds noch dunkler wirken können, da die nicht leuchtenden Flächen 9 überwiegen.

**Fig. 2** zeigt eine rein qualitative Veranschaulichung eines Abstands 11, der kleiner ist als das Auflösungsvermögen des Betrachters 50 und der bei dem Betrachter unter einem Winkel 51 von maximal zwei Winkelminuten erscheint. Bei einem solchen Abstand 11 können die meisten Betrachter 50 zwei verschiedene Pixel 10 nicht mehr wahrnehmen und sie erhalten somit einen besonders hochwertigen und konntinuierlichen Bildeindruck.

In den nachfolgenden Figuren sind verschiedene Ausgestaltungsmöglichkeiten aus Platzgründen auch innerhalb einer Anzeigevorrichtung 1 gezeigt, was nicht einschränkend zu werten ist. Es bedeuten, dass die entsprechende Anzeigevorrichtung bevorzugt nur eine Form der gezeigten Ausgestaltungsmöglichkeiten (angewendet auf alle Leuchtflächen / Pixel) aufweist oder eine Mischung verschiedener Ausgestaltungsmöglichkeiten (z.B. wie dann dargestellt).

**Fig. 3a und 3b** zeigen Ausschnitte von Anzeigevorrichtungen 2 aufbauend auf Fig. 1 wobei die Anzeigevorrichtung 1 eine Farbanzeigevorrichtung ist. Es ist jeweils eine Seitenansicht oberhalb einer Aufsicht auf die Anzeigefläche 2 gezeigt. Zur besseren Veranschaulichung und Farbunterscheidung sind aber hier Schraffuren verwendet. In **Fig. 3a** sind zwei Pixel 10 gezeigt.Es ist jeweils eine Leuchtfläche 12 einem Pixel 10 zugeordnet, wobei über die Leuchtfläche 12 mehrere Farben an den Betrachter ausgesendet werden. Zwei Möglichkeiten der Zusammensetzung eines Pixels 10 sind dargestellt, links eine Zusammensetzung eines Pixels 10 aus den Farben Rot (enge Schraffur von links oben nach rechts unten), Grün (enge Schraffur von links unten nach rechts oben), Blau (enge Schraffur vertikal) bevorzugt in Streifenanordnung und rechts aus den Farben Rot, Grün, Blau und Weiß (ohne Schraffur) bevorzugt in annähernd quadratischer Anordnung. Komponenten mit einer weiten Schraffur von links oben nach links unten, so wie hier die nicht leuchtenden Flächen 9, sind bevorzugt lichtundurchlässig.

In **Fig. 3b** ist ein Pixel 10 dargestellt, dem drei Leuchtflächen 12 zugeordnet sind, wobei über eine erste Leuchtfläche 12 Rot, über eine zweite Leuchtfläche 12 Grün und über eine dritte Leuchtfläche 12 Blau an den Betrachter aussendbar ist. Die Abstände 11.1 der Flächenschwerpunkte benachbarter Leuchtflächen 12 betragen 1/3 des Abstands 11, der kleiner ist als das Auflösungsvermögen des Betrachters 50.

**Fig. 4a** **bis 7b** zeigen, wie auf verschiedene Weise die zweidimensionale Struktur einer Anzeigefläche 2 gemäß dem Prinzip, einen Anteil von nicht leuchtenden Flächen 9 an der gesamten Anzeigefläche 2 von mehr als 70% vorzusehen, erhalten werden kann. Optische Achsen sind jeweils gestrichpunktet eingezeichnet und teilweise ist am unteren Ende der Achse ein bevorzugtes Leuchtmuster bzw. -Farbe der entsprechenden Lichtquelle 21 angegeben und am oberen Ende der Achse ein sich bevorzugt ergebendes Leuchtmuster bzw. -farbe auf der Leuchtfläche 12.

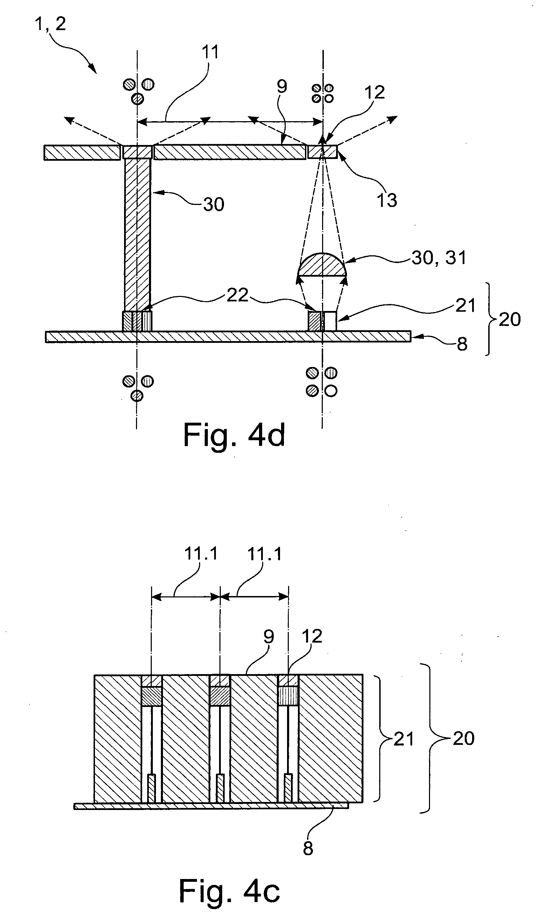

**Fig. 4a bis 4e** zeigen Ausschnitte von Anzeigevorrichtungen 1 aufbauend auf Fig. 3a oder 3b. Die Anzeigevorrichtung 1 weist eine Beleuchtungseinrichtung 20 mit einem Substrat 8 auf, auf dem mehrere Lichtquellen 21 angeordnet sind, wobei dabei bevorzugt die Lichtquellen 21 kleine Lichtquellen 21 sind (z.B. VCSEL-Laser), d.h. bevorzugt Lichtquellen 21, bei denen der Flächeninhalt der aktiven Leuchtfläche 22 kleiner oder gleich dem Flächeninhalt der entsprechenden Leuchtfläche 12 ist. Fig. 4a und 4d zeigen Lichtquellen 21, die polychromatisch sind, d.h. die eingerichtet sind, verschiedene, variable Anteile von Licht mit verschiedenen Wellenlängen zu emittieren, z.B. Rot, Grün, Blau-Anteile. Fig. 4b, 4c und 4e zeigen Lichtquellen 21, die monochromatisch sind, d.h. die einen nicht variablen Wellenlängenbereich bzw. festen Mix verschiedener Wellenlängen emittieren.

In **Fig. 4a** sind die Leuchtflächen 12 jeweils durch eine der Lichtquellen 21 gebildet. Die nicht leuchtenden Flächen 9 der Anzeigefläche 2 sind durch Flächen eines Füllmaterials zwischen den Lichtquellen 21 gebildet, was genauso auch bei Fig. 4b so vorgesehen sein könnte. **In** **Fig. 4b** sind die Leuchtflächen 12 jeweils durch eine der Lichtquellen 21 gebildet. Die nicht leuchtenden Flächen 9 der Anzeigefläche 2 sind durch Flächen des Substrats 8 gebildet, was genauso auch bei Fig. 4a so vorgesehen sein könnte.ln **Fig. 4a und 4b** ist die aktive Leuchtfläche 22 der jeweiligen Lichtquelle 21 somit gleichermaßen eine Leuchtfläche 12 der Anzeigefläche 2. Mit wenigen Bauteilen kann somit eine Anzeigevorrichtung hergestellt werden, wobei dafür jedoch vorteilhafterweise qualitativ sehr hochwertige, helle und präzise abgemessene Lichtquellen verwendet werden sollten.

In **Fig. 4c** sind die Leuchtflächen 12 jeweils durch ein von einer der Lichtquellen 21 beleuchtbares transparentes Abdeckelement gebildet. Die nicht leuchtenden Flächen 9 der Anzeigefläche 2 sind durch Flächen eines Füllmaterials zwischen den Lichtquellen 21 gebildet. Jede Lichtquelle 21 weist eine Leuchtstoffschicht und einen Elektronen-Emitter auf, welcher eingerichtet ist, durch Aussendung eines Elektronenstrahls die Leuchtstoffschicht zum aktiven Leuchten zu bringen. Die Leuchtstoffschicht kann dabei auch als Streuelement angesehen werden, da es die eintreffende Strahlungsenergie aus einer Richtung in mehrere Richtungen verteilt. Zwischen dem Elektronen-Emitter und der Leuchtstoffschicht liegt jeweils ein Vakuum in einer Vakuumzelle vor.

Vorteilhaft dabei ist, dass aufgrund des Prinzips einer großen Zwischenfläche zwischen den Leuchtflächen auch eine sehr gute und günstige Abdichtung der Vakuumzellen möglich ist.

In **Fig. 4d** sind die Leuchtflächen 12 jeweils durch ein von einer der Lichtquellen 21 beleuchtbares optisches Streuelement 13 (weite Schraffur von links unten nach rechts oben - diese Art Schraffur bedeutet bevorzugt, dass die derart schraffierte Komponente, z.B. auch später Linsen, lichtdurchlässig, bevorzugt im Wesentlichen ohne Farbfilterung, ist) gebildet. Die nicht leuchtenden Flächen 9 der Anzeigefläche 2 sind durch Flächen eines Füllmaterials zwischen den Lichtquellen 21, auf Höher der Streuelemente 12, gebildet. Es sind zwei Ausgestaltungsmöglichkeiten gezeigt, links mit einem sog. Light-Guide (z.B. eine Glasfaser) als Strahlformeinrichtung 30, die auch als Konzentrator 31 dient, rechts mit einer Linse als Konzentrator 31. Das sich ergebende Leuchtmuster auf der Leuchtfläche 12 ist wie oben angedeutet, links etwa in gleicher Größe wie das Leuchtmuster der Leuchtfläche 22, rechts etwas verkleinert. Zudem ist das sich ergebende Leuchtmuster diffuser, bevorzugt mit untereinander durchmischten Farben, was aufgrund des Streuelements 13 erfolgt, zeichnungstechnisch jedoch nicht vorteilhaft darstellbar ist. Hierdurch wird eine gestreute Abstrahlung erreicht, gleichzeitig jedoch eine Bündelung des Lichts auf die Streuelemente 13.

**In** **Fig. 4e** sind die Leuchtflächen 12 jeweils durch ein von einer der Lichtquellen 21 beleuchtbares optisches Farbfilterelement 14 gebildet. Die nicht leuchtenden Flächen 9 der Anzeigefläche 2 sind durch Flächen eines Füllmaterials zwischen den Lichtquellen 21, auf Höhe der Farbfilterelemente 14, gebildet. Jede Lichtquelle 21 weist einen UV-Emitter auf, welcher eingerichtet ist, durch Aussendung eines UV-Lichtstrahls eine Leuchtstoffschicht, die hier z.B. auch als Streuelement 13 wirkt, zum aktiven Leuchten zu bringen. Die verschiedenen Farben, hier RGB, werden somit durch die Farbfilterelemente 14 erhalten, z.B. durch Quantum Dots. Es sind weiterhin drei Ausgestaltungsmöglichkeiten gezeigt, links und rechts Strahlformelemente 30 wie in Fig. 4d und in der Mitte eine Variante ohne Strahlformelement 30.

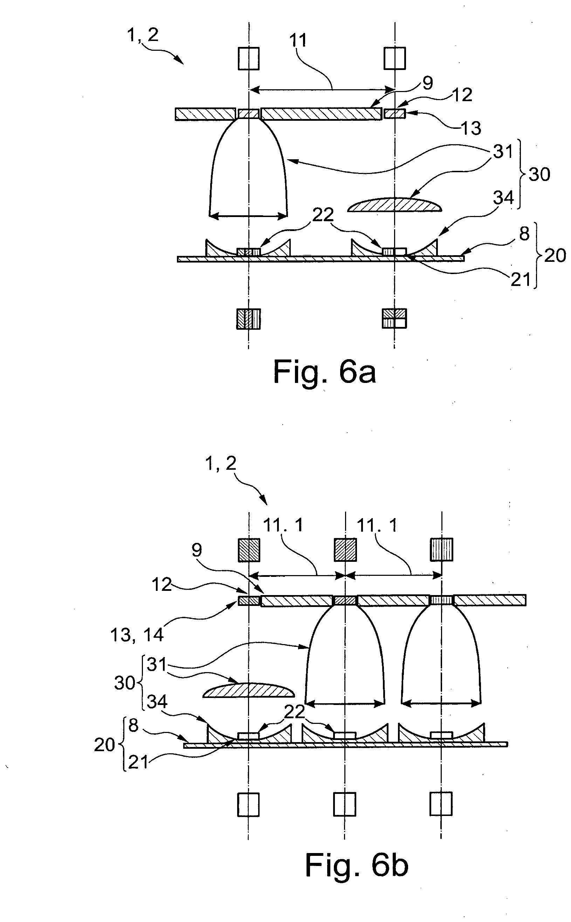

Bevorzugt ist in Fig. 4d und 4e ein Kollimator 34 Teil der Strahlformeinrichtung 30, analog zu z.B. Fig. 6a.

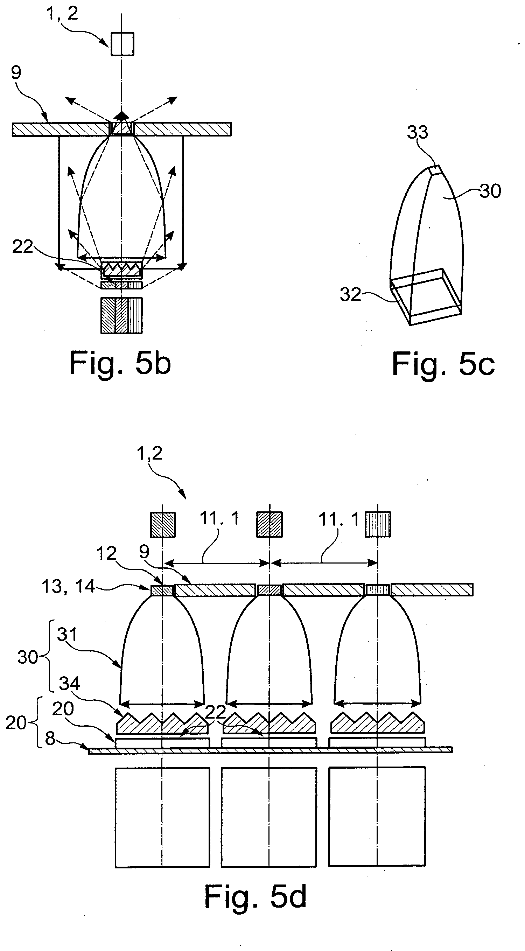

**Fig. 5a bis 6d** zeigen Ausschnitte erfindungsgemäßer Anzeigevorrichtungen 1 aufbauend auf Fig. 3a oder 3b. Diese weisen im Vergleich zu Fig. 4a-4e größere Lichtquellen 21 auf und insbesondere jeweils optische Strahlformeinrichtungen 30, die zwischen der Beleuchtungseinrichtung 20 und der Anzeigefläche 2 angeordnet sind, und jeder Strahlformeinrichtung 30 ist eine Leuchtfläche 12 zugeordnet und die Strahlformeinrichtungen 30 sind jeweils eingerichtet, Licht von der Beleuchtungseinrichtung 20 auf die jeweilige Leuchtfläche12 zu konzentrieren. Die aktiven Leuchtflächen 22 der Lichtquellen 21 weisen jeweils einen Flächeninhalt auf, der größer als der jeweilige Flächeninhalt der Leuchtfläche 12 der Anzeigefläche 2 ist. Die Anzeigevorrichtungen 1 weisen jeweils optische Strahlformeinrichtungen 30 auf, die zwischen der Beleuchtungseinrichtung 20 und der Anzeigefläche 2 angeordnet sind, und jeder Strahlformeinrichtung 30 ist eine Leuchtfläche 12 zugeordnet und die Strahlformeinrichtungen 30 sind jeweils eingerichtet, Licht von der Beleuchtungseinrichtung 20 auf die jeweilige Leuchtfläche 12 zu konzentrieren. Die optischen Strahlformeinrichtungen 30 weisen jeweils einen optischen Kollimator 34 (z.B. eine halb-sphärische Kollimatorlinse) und einen optischen Konzentrator 31 mit gekrümmten Reflektorflächen auf und der optische Kollimator 34 ist jeweils bezüglich einer Propagationsrichtung des Lichts der Beleuchtungseinrichtung 20 vor dem Konzentrator 31 angeordnet, so dass Licht zunächst im wesentlichen kollimierbar und dann konzentrierbar ist. Als Konzentrator 31 ist einerseits ein compound parabolic concentrator (CPC) vorgesehen (abgebildet durch zwei gegenüberliegende gekrümmte, bevorzugt parabolisch gekrümmte Reflektorflächen und perspektivisch auch in Fig. 5c), alternativ eine Kondensorlinse 31 (z.B. Fig. 6a rechts). Als Kollimatoren 34 sind einerseits Prismenkollimatoren 34 (gezeichnet durch eine pyradmidiale Struktur) oder alternativ Reflektoren 34 (wie in Fig. 6a bis Fig. 6d) vorhanden.

In **Fig. 5a****,** **5b und 5d** weisen die Anzeigevorrichtungen 1 Lichtquellen 21 auf, die annähernd Lambert-Strahler sind. **In** **Fig. 5a** sind Leuchtflächen 12 jeweils durch ein von der Beleuchtungseinrichtung 20 beleuchtbares optisches Streuelement 13 gebildet. Die nicht leuchtenden Flächen 9 der Anzeigefläche 2 sind durch Flächen eines zwischen den Streuelementen 13 angeordneten Füllmaterials gebildet, wobei das Füllmaterial hier als Fläche dargestellt ist, jedoch ebenso zudem den Zwischenraum zwischen benachbarten Strahlformelementen 30 komplett ausfüllen kann. Die Lichtquellen sind polychromatisch und die Lichtquellen bzw. deren aktive Leuchtflächen weisen eine Ausdehnung auf, die mehr als 50% des Abstands 11 der Flächenschwerpunkte der Leuchtflächen 12 betragen. Die CPCs 31 weisen einen Eingang 32 und einen Ausgang 33 auf (siehe auch Fig. 5c), wobei der Eingang 32 eine größere Fläche aufweist als der Ausgang 33 und der Ausgang 33 der Leuchtfläche 12 sowie der Anzeigefläche 2 zugewandt ist und der Eingang 32 der Beleuchtungseinrichtung 20 zugewandt ist. Der CPC weist einen optischen Eingangswinkel 37 auf, welcher maximal um 30°-10°, bevorzugt 20°, kleiner ist, als der optische Ausgangswinkel 36 des Prismenkollimators 34. Somit können optische Verluste 35 möglichst minimiert werden. Durch die Kombination von Kollimator 34 und Konzentrator 31 findet eine effektive Lichtkonzentration auf die Leuchtflächen 12 statt. Zudem wird durch den CPC als nicht abbildende Optik eine sehr homogene Farbmischung erreicht, was durch die weißen Ausgangsleuchtmuster angedeutet ist. Das Streuelement 13 erlaubt einen großen Betrachtungswinkel. Der Strahlengang des Lichts ist durch gestrichelte Pfeile angedeutet. In **Fig. 5b** ist eine Variante der Anzeigevorrichtung aus Fig. 5a dargestellt, bei welcher die Ausdehnung der Lichtquelle 21 kleiner als 50% des Abstands 11, jedoch größer als die Ausdehnung der Leuchtfläche 12 ist. In Fig. 5d sind im Unterschied zu Fig. 5a die Lichtquellen monochromatisch und die Leuchtflächen 12 sind jeweils durch ein von der Beleuchtungseinrichtung 20 beleuchtbares optisches Farbfilterelement, das gleichzeitig ein Streuelement 13 ist, gebildet. Weiterhin ergeben sich Abstände 11.1 zwischen den Leuchtflächen 12, die ein Drittel des Abstands 11 betragen.

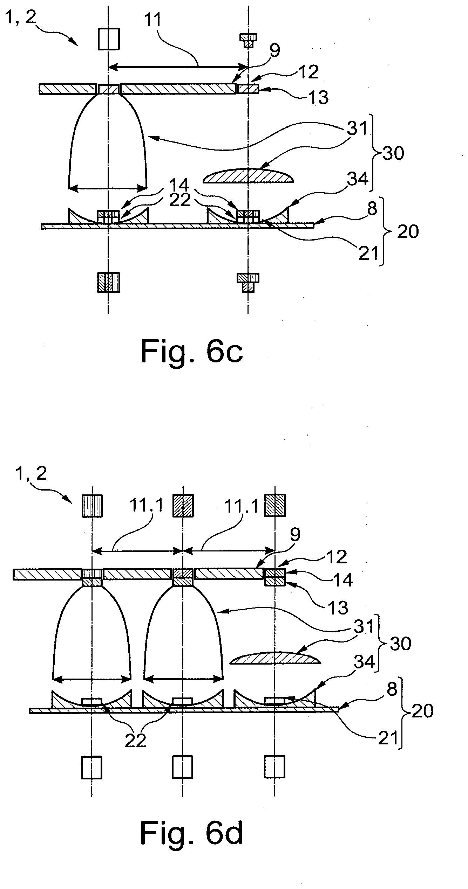

In **Fig. 6a, 6b****,** **6c und 6d** weisen die Anzeigevorrichtungen 1 Lichtquellen 21 auf, die flächenmäßig (z.B. bezogen auf die aktive Leuchtfläche einer Lichtquelle) gleich groß oder größer als die Leuchtflächen 12 sind. Ansonsten ist **Fig. 6a** ähnlich zu Fig. 5a, wobei Fig. 6a im Unterschied zu Fig. 5a Kollimatoren 34 zeigt, welche als Parabolreflektor die Lichtquellen 21 umgeben. Der optische Kollimator 34 ist nach wie vor bezüglich einer Propagationsrichtung des Lichts der Beleuchtungseinrichtung 20 vor dem Konzentrator 31 angeordnet, so dass Licht zunächst im wesentlichen kollimierbar und dann konzentrierbar ist. Als Variante ist rechts eine RGBW-Lichtquelle gezeigt sowie anstatt eines CPCs als Konzentrator 31 eine Kondensorlinse, hier eine nicht-abbildende Kondensorlinse, die ebenfalls eine gute Homogenisierung des durch die Leuchtfläche 12 durchstrahlenden Lichts bewirkt. **Fig. 6b** ist ähnlich zu Fig. 6a, wobei die Lichtquellen 21 monochromatisch sind und die Leuchtflächen 12 jeweils durch ein von der Beleuchtungseinrichtung 20 beleuchtbares optisches Farbfilterelement, das gleichzeitig ein Streuelement 13 ist, gebildet sind. Weiterhin ergeben sich Abstände 11.1 zwischen den Leuchtflächen 12, die ein Drittel des Abstands 11 betragen. **Fig. 6c** ist ähnlich zu Fig. 6a, wobei die Lichtquellen 21 monochromatisch, hier weiß, sind und direkt auf den Lichtquellen 21 Farbfilterelemente 14 angeordnet sind. Weiterhin ist rechts eine Ausgestaltungsmöglichkeit mit einer abbildenden Kondensorlinse 31 gezeigt. **Fig. 6d** ist ähnlich zu Fig. 6a, wobei die Lichtquellen 21 monochromatisch, hier z.B. im Wesentlichen Blau- und/oder UV-emittierend sind. Die Leuchtflächen 12 sind jeweils durch ein von der Beleuchtungseinrichtung 20 beleuchtbares optisches Farbfilterelement 14 gebildet. Jede Lichtquelle 21 weist einen Blau- und/oder UV-Emitter auf, welcher eingerichtet ist, durch Aussendung eines Blau- und/oder UV-Lichtstrahls eine Leuchtstoffschicht, die hier z.B. auch als Streuelement 13 wirkt, zum aktiven Leuchten zu bringen. Die verschiedenen Farben, hier RGB, werden somit durch die Farbfilterelemente 14 erhalten. Weiterhin ergeben sich Abstände 11.1 zwischen den Leuchtflächen 12, die ein Drittel des Abstands 11 betragen. Direkt auf den Lichtquellen 21 sind Farbfilterelemente 14 angeordnet (z.B. Quantum Dots).

In allen gezeigten Ausführungen weisen bevorzugt die nicht leuchtenden Flächen 9, bevorzugt die gesamte Anzeigefläche 2 einen Reflexionsgrad diffuser Reflexion und/oder spiegelnder Reflexion von weniger als 50 % auf. Die nicht leuchtenden Flächen 9 weisen hierfür bevorzugt eine dunkle Farbe auf oder sind schwarz und/oder sie weisen einen Mittenrauwert im Bereich von 0,2 µm und 1,0 µm auf und/oder sind mittels einer Antireflexbeschichtung beschichtet. Bevorzugt ist zudem eine elektronische Kompensationseinrichtung vorhanden, mittels welcher eine minimale Helligkeit der Leuchtflächen 12 für die Anpassung der Darstellung schwarzer Bildpixel in Abhängigkeit der Umgebungshelligkeit automatisch einstellbar ist.

Mit dieser Erfindung wird eine revolutionäre Qualitätsverbesserung von Anzeigevorrichtungen geschaffen. Die Bildqualität wird durch das Prinzip, die zwischen den Leuchtflächen liegenden nicht leuchtenden Flächen möglichst groß auszulegen, z.B. indem der Anteil der nicht leuchtenden Flächen an der gesamten Anzeigefläche mindestens 70% beträgt, erhöht, da hierdurch der Kontrast verbessert wird und viel Energie gespart werden kann, was insbesondere für tragbare Geräte sehr wichtig ist. Durch ein zusätzliches Vorsehen der nicht leuchtenden Flächen mit einem geringen Reflexionsgrad (spiegelnd oder diffus) werden schwarze Bildbestandteile auch schwarz bleiben. Um die hellen Bildbereiche noch heller machen zu können, und auch, um den Helligkeitsverlust durch die Verringerung des Flächenanteils der Leuchtflächen auszugleichen, werden spezielle intensive Lichtquellen (z.B. Laser oder micro-LEDs oder micro-OLEDS) verwendet oder es wird mittels spezieller Strahlformeinrichtungen, welche vom Betrachter aus gesehen hinter der Anzeigefläche liegen, eine Konzentration von Licht auf die Leuchtflächen und somit ein Helligkeits-Boost erreicht, so dass der Helligkeit-Mittelwert ähnlich ist wie auf normalen Display-Einrichtungen, jedoch mit besserem Kontrast und kleinerem Energieverbrauch, je nach Umgebungslicht.

### Bezugszeichen

- 1: Anzeigevorrichtung
- 2: Anzeigefläche der Anzeigevorrichtung
- 8: Substrat
- 9: nicht leuchtende Fläche
- 10: Pixel
- 11: Abstand
- 11.1: 1/3 des Abstands 11
- 12: Leuchtfläche
- 13: Streuelement
- 14: Farbfilterelement
- 20: Beleuchtungseinrichtung
- 21: Lichtquelle
- 22: aktive Leuchtfläche der Lichtquelle
- 30: optische Strahlformeinrichtung
- 31: optischer Konzentrator
- 32: Eingang des optischen Konzentrators
- 33: Ausgang des optischen Konzentrators
- 34: optischer Kollimator
- 35: optische Verluste
- 36: Ausgangswinkel des optischen Kollimator
- 37: Eingangswinkel des optischen Konzentrators
- 50: Betrachter
- 51: Einfallswinkel

## Patentansprüche

1. Farbanzeigevorrichtung (1) mit einer Anzeigefläche (2) mit einer Vielzahl von Pixeln, wobei die Anzeigefläche aus nicht leuchtenden Flächen (9) und Leuchtflächen (12) besteht wobei jeweils eine Leuchtfläche (12) einem Pixel bestehend aus mehreren Farben zugeordnet ist, wobei die Anzeigefläche (2) eine dem Betrachter zugewandte Fläche der Anzeigevorrichtung (1) ist, wobei die Flächenschwerpunkte benachbarter Leuchtflächen (12) gegenseitige Abstände (11, 11.1) aufweisen, die maximal 190 µm betragen, und wobei der Anteil der nicht leuchtenden Flächen (9) an der gesamten Anzeigefläche (2) mehr als 70% beträgt, wobei die Anzeigevorrichtung (1) eine Beleuchtungseinrichtung (20) mit einem Substrat (8) aufweist, auf dem mehrere Lichtquellen (21) angeordnet sind, wobei die Anzeigevorrichtung (1) optische Strahlformeinrichtungen (30) aufweist, die zwischen der Beleuchtungseinrichtung (20) und der Anzeigefläche (2) angeordnet sind, und wobei jeder Strahlformeinrichtung (30) eine Leuchtfläche (12) zugeordnet ist und die Strahlformeinrichtungen (30) jeweils eingerichtet sind, Licht von der Beleuchtungseinrichtung (20) auf die jeweilige Leuchtfläche (12) zu konzentrieren, wobei jede optische Strahlformeinrichtung (30) mindestens eine gekrümmte oder abgestufte Reflektorfläche aufweist.

2. Farbanzeigevorrichtung (1) gemäß Anspruch 1, wobei die Flächenschwerpunkte benachbarter Leuchtflächen (12) gegenseitige Abstände (11, 11.1) aufweisen, die maximal 80 µm betragen, und wobei die Ausdehnung jeder Leuchtfläche höchstens 25 µm beträgt.

3. Farbanzeigevorrichtung (1) gemäß Anspruch 1 oder 2, wobei die Anzeigefläche (2) eine Vielzahl solcher Pixel (10) aufweist, die in einem sich wiederholenden Muster angeordnet sind, so dass aus den Pixeln (10) Bilder zusammengesetzt werden können.

4. Farbanzeigevorrichtung (1) gemäß einem der vorhergehenden Ansprüche, wobei eine Mehrheit der nicht leuchtenden Flächen (9) einen Reflexionsgrad diffuser Reflexion von weniger als 50 % aufweist.

5. Farbanzeigevorrichtung (1) gemäß einem der vorhergehenden Ansprüche, wobei eine Mehrheit der nicht leuchtenden Flächen (9) einen Reflexionsgrad spiegelnder Reflexion von weniger als 50 % aufweist.

6. Farbanzeigevorrichtung (1) gemäß einem der vorhergehenden Ansprüche, wobei eine Mehrheit der nicht leuchtenden Flächen (9) eine dunkle Farbe aufweist oder schwarz ist und/oder wobei eine Mehrheit der nicht leuchtenden Flächen (9) einen Mittenrauwert im Bereich von 0,2 µm und 1,0 µm aufweist und/oder wobei eine Mehrheit der nicht leuchtenden Flächen (9) mittels einer Antireflexbeschichtung beschichtet ist.

7. Farbanzeigevorrichtung (1) gemäß einem der vorhergehenden Ansprüche, wobei die Anzeigevorrichtung (1) eine elektronische Kompensationseinrichtung aufweist, mittels welcher eine minimale Helligkeit der Leuchtflächen (12) für die Anpassung der Darstellung schwarzer Bildpixel in Abhängigkeit der Umgebungshelligkeit automatisch einstellbar ist.

8. Farbanzeigevorrichtung (1) gemäß Anspruch 1, wobei die Leuchtflächen (12) jeweils durch eine der Lichtquellen (21) oder durch ein von einer der Lichtquellen (21) beleuchtbares optisches Streuelement (13) oder transparentes Abdeckelement oder optisches Farbfilterelement (14) gebildet sind und wobei die nicht leuchtenden Flächen (9) der Anzeigefläche (2) durch Flächen des Substrats (8) und/oder durch Flächen eines Füllmaterials zwischen den Leuchtflächen (12) gebildet sind.

9. Farbanzeigevorrichtung (1) gemäß Anspruch 8, wobei jede Lichtquelle (21) einen Elektronen-Emitter aufweist, welcher eingerichtet ist, durch Aussendung eines Elektronenstrahls eine Leuchtstoffschicht zum aktiven Leuchten zu bringen, oder einen UV-Emitter aufweist, welcher eingerichtet ist, durch Aussendung eines UV-Lichtstrahls die Leuchtstoffschicht zum aktiven Leuchten zu bringen.

10. Farbanzeigevorrichtung (1) gemäß einem der Ansprüche 1 bis 7, wobei jeweils die aktiven Leuchtflächen (22) der Lichtquellen (21) einen Flächeninhalt aufweisen, der größer als die Flächeninhalte der Leuchtflächen (12) der Anzeigefläche (2) ist.

11. Farbanzeigevorrichtung (1) gemäß Anspruch 10, wobei die Leuchtflächen (12) jeweils durch ein von der Beleuchtungseinrichtung (20) beleuchtbares optisches Streuelement (13) oder transparentes Abdeckelement gebildet sind, und wobei die nicht leuchtenden Flächen (9) der Anzeigefläche (2) durch Flächen eines zwischen Leuchtflächen (12) angeordneten Füllmaterials oder Substrats gebildet sind.

12. Farbanzeigevorrichtung (1) gemäß Anspruch 1, wobei die optischen Strahlformeinrichtungen (30) jeweils einen optischen Kollimator (34) aufweisen.

13. Farbanzeigevorrichtung (1) gemäß einem der Ansprüche 1 oder 12, wobei die optischen Strahlformeinrichtungen (30) jeweils einen optischen Konzentrator (31) aufweisen.

## Claims

1. Colour display device (1) having a display area (2) with a plurality of pixels, wherein the display area consists of non-illuminated areas (9) and illuminated areas (12), wherein in each case one illuminated area (12) is assigned to one pixel consisting of multiple colours, wherein the display area (2) is an area of the display device (1) facing the viewer, wherein the centroids of adjacent illuminated areas (12) are located at distances (11, 11.1) of at most 190 µm from each other, and wherein the proportion of non-illuminated areas (9) in the entire display area (2) is more than 70%, wherein the display device (1) has an illumination device (20) with a substrate (8) on which a plurality of light sources (21) are arranged, wherein the display device (1) has optical beam-shaping devices (30) which are arranged between the illumination device (20) and the display area (2), and wherein an illuminated area (12) is assigned to each beam-shaping device (30) and the beam-shaping devices (30) are each designed to concentrate light from the illumination device (20) onto the respective illuminated area (12), wherein each optical beam-shaping device (30) has at least one curved or stepped reflector surface.

2. Colour display device (1) according to claim 1, wherein the centroids of adjacent illuminated areas (12) are located at distances (11, 11.1) of at most 80 µm from each other, and wherein the extent of each illuminated area is at most 25 µm.

3. Colour display device (1) according to claim 1 or 2, wherein the display area (2) has a plurality of such pixels (10) which are arranged in a repeating pattern, with the result that images can be composed from the pixels (10).

4. Colour display device (1) according to any one of the preceding claims, wherein a majority of the non-illuminated areas (9) have a reflectance of diffuse reflection of less than 50%.

5. Colour display device (1) according to any one of the preceding claims, wherein a majority of the non-illuminated areas (9) have a reflectance of specular reflection of less than 50%.

6. Colour display device (1) according to any one of the preceding claims, wherein a majority of the non-illuminated areas (9) have a dark colour or are black, and/or wherein a majority of the non-illuminated areas (9) have a mean roughness index in the range from 0.2 um to 1.0 µm, and/or wherein a majority of the non-illuminated areas (9) are coated by means of an anti-reflection coating.

7. Colour display device (1) according to any one of the preceding claims, wherein the display device (1) has an electronic compensation device, by means of which a minimum brightness of the illuminated areas (12) can be set automatically for adapting the representation of black image pixels in dependence on the ambient brightness.

8. Colour display device (1) according to claim 1, wherein each of the illuminated areas (12) is formed by one of the light sources (21) or by an optical scatter element (13) or transparent cover element or optical colour-filter element (14) which can be illuminated by one of the light sources (21), and wherein the non-illuminated areas (9) of the display area (2) are formed by areas of the substrate (8) and/or by areas of a filling material between the illuminated areas (12).

9. Colour display device (1) according to claim 8, wherein each light source (21) has an electron emitter which is set up to cause a layer of luminescent material to actively light up by emitting an electron beam, or each light source has a UV emitter which is set up to cause the layer of luminescent material to actively light up by emitting a UV light beam.

10. Colour display device (1) according to any one of claims 1 to 7, wherein in each case the active illuminated areas (22) of the light sources (21) have a surface area which is greater than the surface areas of the illuminated areas (12) of the display area (2).

11. Colour display device (1) according to claim 10, wherein each of the illuminated areas (12) is formed by an optical scatter element (13) or transparent cover element which can be illuminated by the illumination device (20), and wherein the non-illuminated areas (9) of the display area (2) are formed by areas of a filling material or substrate arranged between illuminated areas (12).

12. Colour display device (1) according to claim 1, wherein each of the optical beam-shaping devices (30) has an optical collimator (34).

13. Colour display device (1) according to any one of claims 1 or 12, wherein each of the optical beam-shaping devices (30) has an optical concentrator (31).

## Revendications

1. Dispositif d'affichage couleur (1) avec une surface d'affichage (2) avec une pluralité de pixels, dans lequel la surface d'affichage se compose de surfaces non lumineuses (9) et de surfaces lumineuses (12), dans lequel une surface lumineuse (12) est respectivement attribuée à un pixel composé de plusieurs couleurs, dans lequel la surface d'affichage (2) est une surface du dispositif d'affichage (1) tournée vers l'observateur, dans lequel les centres de gravité de surface de surfaces lumineuses (12) avoisinantes présentent des distances (11, 11.1) mutuelles qui s'élèvent au maximum à 190 µm, et dans lequel la proportion des surfaces non lumineuses (9) par rapport à la totalité de la surface d'affichage (2) s'élève à plus de 70 %, dans lequel le dispositif d'affichage (1) présente un équipement d'éclairage (20) avec un substrat (8) sur lequel sont agencées plusieurs sources lumineuses (21), dans lequel le dispositif d'affichage (1) présente des équipements de forme de faisceau (30) optiques qui sont agencés entre l'équipement d'éclairage (20) et la surface d'affichage (2), et dans lequel une surface lumineuse (12) est attribuée à chaque équipement de forme de faisceau (30) et les équipements de forme de faisceau (30) sont respectivement aménagés de façon à concentrer une lumière depuis l'équipement d'éclairage (20) jusque sur la surface lumineuse (12) respective, dans lequel chaque équipement de forme de faisceau (30) optique présente au moins une surface de réflexion courbe ou en gradins.

2. Dispositif d'affichage couleur (1) selon la revendication 1, dans lequel les centres de gravité de surface de surfaces lumineuses (12) avoisinantes présentent des distances (11, 11.1) mutuelles qui s'élèvent au maximum à 80 µm, et dans lequel l'extension de chaque surface lumineuse s'élève au plus à 25 µm.

3. Dispositif d'affichage couleur (1) selon la revendication 1 ou 2, dans lequel la surface d'affichage (2) présente une pluralité de pixels (10) qui sont agencés dans un motif se répétant de sorte que des images puissent être composées à partir de ces pixels (10).

4. Dispositif d'affichage couleur (1) selon l'une des revendications précédentes, dans lequel une majorité des surfaces non lumineuses (9) présente une réflectance de réflexion diffuse inférieure à 50 %.

5. Dispositif d'affichage couleur (1) selon l'une des revendications précédentes, dans lequel une majorité des surfaces non lumineuses (9) présente une réflectance de réflexion spéculaire inférieure à 50 %.

6. Dispositif d'affichage couleur (1) selon l'une des revendications précédentes, dans lequel une majorité des surfaces non lumineuses (9) présente une couleur sombre ou est noire et/ou dans lequel une majorité des surfaces non lumineuses (9) présente une valeur de rugosité moyenne dans la plage de 0,2 µm et 1,0 µm et/ou dans lequel une majorité des surfaces non lumineuses (9) est revêtue au moyen d'un revêtement antireflet.

7. Dispositif d'affichage couleur (1) selon l'une des revendications précédentes, dans lequel le dispositif d'affichage (1) présente un équipement de compensation électronique au moyen duquel une luminosité minimale des surfaces lumineuses (12) peut être réglée automatiquement pour l'ajustement de la représentation de pixels d'image noirs en fonction de la luminosité environnante.

8. Dispositif d'affichage couleur (1) selon la revendication 1, dans lequel les surfaces lumineuses (12) sont respectivement formées par l'une des sources lumineuses (21) ou par un élément de diffusion (13) optique ou un élément de recouvrement transparent ou un élément de filtre coloré (14) optique pouvant être éclairés par l'une des sources lumineuses (21) et dans lequel les surfaces non lumineuses (9) de la surface d'affichage (2) sont formées par des surfaces du substrat (8) et/ou par des surfaces d'un matériau de remplissage entre les surfaces lumineuses (12).

9. Dispositif d'affichage couleur (1) selon la revendication 8, dans lequel chaque source lumineuse (21) présente un émetteur d'électrons, lequel est aménagé pour provoquer l'éclairage actif d'une couche de substance luminescente par l'émission d'un faisceau d'électrons, ou présente un émetteur d'UV, lequel est aménagé pour provoquer l'éclairage actif de la couche de substance luminescente par l'émission d'un faisceau de lumière UV.

10. Dispositif d'affichage couleur (1) selon l'une des revendications 1 à 7, dans lequel les surfaces lumineuses actives (22) des sources lumineuses (21) présentent respectivement une superficie qui est supérieure aux superficies des surfaces lumineuses (12) de la surface d'affichage (2).

11. Dispositif d'affichage couleur (1) selon la revendication 10, dans lequel les surfaces lumineuses (12) sont respectivement formées par un élément de diffusion (13) optique ou un élément de recouvrement transparent pouvant être éclairés par l'équipement d'éclairage (20), et dans lequel les surfaces non lumineuses (9) de la surface d'affichage (2) sont formées par des surfaces d'un matériau de remplissage ou d'un substrat agencés entre des surfaces lumineuses (12).

12. Dispositif d'affichage couleur (1) selon la revendication 1, dans lequel les équipements de forme de faisceau (30) optiques présentent respectivement un collimateur (34) optique.

13. Dispositif d'affichage couleur (1) selon l'une des revendications 1 ou 12, dans lequel les équipements de forme de faisceau (30) optiques présentent respectivement un concentrateur (31) optique.
